# EUROPEAN PATENT APPLICATION

(11) **EP 4 424 441 A1**
(43) Date of publication of application: **04.09.2024**
(21) Application number: 22886907.9
(22) Date of filing: 21.10.2022
(51) Int. Cl.: B22F 7/08, B22F 1/00, B22F 9/00, H01L 21/52

(54) **SINTERED MATERIAL, METAL SINTERED COMPACT, MANUFACTURING METHOD FOR SINTERED MATERIAL, MANUFACTURING METHOD FOR JOINED BODY, AND JOINED BODY**

(30) Priority: 25.10.2021 JP 2021173794; 06.10.2022 JP 2022161807
(71) Applicant: Toppan Holdings Inc., Tokyo 110-0016 (JP); OSAKA UNIVERSITY, Suita-shi Osaka 565-0871 (JP)
(72) Inventor: SEKIGUCHI, Takuya, Tokyo 105-8311 (JP); CHEN, Chuantong, Suita-shi, Osaka 565-0871 (JP); SUGANUMA, Katsuaki, Suita-shi, Osaka 565-0871 (JP)
(74) Representative: TBK
(86) International application number: PCT/JP2022/039344
(87) International publication number: WO 2023/074580

(57) **Abstract**

A sintered material containing silver particles, copper particles, a nitrogen-containing compound, and a reducing agent, in which a primary particle diameter of the silver particles is 200 nm or less, and a volume-based 50% cumulative particle diameter of the copper particles, as measured by laser diffraction/scattering particle diameter distribution measurement, is 1 µm or more.

## Description

### [Technical Field]

The present invention relates to a sintered material, a metal sintered compact, a method for producing a sintered material, a method for producing a joined body, and a joined body.

Priority is claimed on Japanese Patent Application No. 2021-173794, filed on October 25, 2021, and Japanese Patent Application No. 2022-161807, filed on October 6, 2022, the contents of which are incorporated herein by reference.

### [Background Art]

Wide bandgap (WBG) semiconductors such as a silicon carbide (SiC) semiconductor and a gallium nitride (GaN) semiconductor are anticipated as next-generation power semiconductors. In recent years, technologies for promoting global environmental measures and reducing power consumption by making full use of power electronic technologies using those power semiconductors have attracted attention.

For example, the power electronic technologies have been applied to various fields such as motor control in industrial equipment, railway vehicles, and the like; reduction in power conversion loss in hybrid vehicles or electric vehicles, and reduction in carbon dioxide emission due to reduction in weight of inverters, and the like; and new energy power conversion such as solar power or wind power generation, and increases in density and efficiency of these technologies have progressed.

The next-generation power semiconductors have a feature of being operable even in an environment at a high temperature of 250°C or higher; however, in such a high temperature environment, lead-free solders (solders using no lead), which are element joining materials in the related art, have a melting point of approximately 250°C, and thus have insufficient heat resistance. Therefore, lead-free solders cannot be used.

Under such circumstances, utilization of a sinter joining technology using silver (Ag)-based nanoparticles has been investigated as a technology for enabling next-generation power electronic devices to operate in a high-temperature environment. Since silver has a melting point of about 1,000°C, it cannot be used as a sintered material as it is at a normal temperature; however, in a case where silver is made into nanoparticles, the surface is more active, and thus silver can be used in this way as a sintered material even at a relatively low temperature of about 200°C to 300°C. However, since silver is an expensive noble metal, the use of a sintered material containing silver particles leads to high cost. Furthermore, silver has a high so-called migration property, in which an arrangement position moves under high humidity conditions, and there is a possibility that silver may be sulfurized by a sulfur component in the atmosphere and corroded (see Non Patent Document 1).

As a solution to such problems, in recent years, sintered materials containing copper (Cu)-based nanoparticles, which are relatively inexpensive and have a low migration property, have attracted attention. However, unlike silver, copper is a metal that is significantly easily oxidized. Therefore, in a case where copper-based nanoparticles are used, sufficient joining strength cannot be obtained unless the copper-based nanoparticles are heated and sintered in a reducing atmosphere or under highpressure conditions of at least 5.5 MPa or more (see Non Patent Document 2). Furthermore, sintering under the high pressure conditions not only increases the cost, but also easily damages a chip and a device, which causes defects in power electronics.

### [Citation List]

### [Non Patent Documents]

[Non Patent Document 1]
   D. Li, et al., Reducing Migration of Sintered Ag for Power Devices Operating at High Temperature, IEEE Transactions on Power Electronics, vol. 35, no. 12, (2020) pp. 12646-12650
[Non Patent Document 2]
   Jeong-Won Yoon, et al.; Effect of Sintering Conditions on the Mechanical Strength of Cu-Sintered Joints for High-Power Applications, Materials, 2018, 11, 2105

### [Summary of Invention]

### [Technical Problem]

An object of the present invention is to provide a sintered material that contains copper particles and enables conductive parts to be joined to each other by calcination without a need to apply high pressure in an atmosphere.

### [Solution to Problem]

[1] A sintered material including:
   silver particles;
   copper particles;
   a nitrogen-containing compound; and
   a reducing agent,
   in which a primary particle diameter of the silver particles is 200 nm or less, and
   a volume-based 50% cumulative particle diameter of the copper particles, as measured by laser diffraction/scattering particle diameter distribution measurement, is 1 µm or more.
[2] The sintered material according to [1], further including:
   a liquid component that is liquid at normal temperature,
   in which the liquid component has either one or both of an ether bond and a hydroxyl group.
[3] The sintered material according to [1] or [2], further including:
   an antioxidative compound having a boiling point of 150°C or higher.
[4] A metal sintered compact including:
   a silver sintered layer,
   in which the silver sintered layer contains copper particles,
   a volume-based 50% cumulative particle diameter of the copper particles, as measured by laser diffraction/scattering particle diameter distribution measurement, is 1 µm or more, and
   surfaces of the copper particles do not have an oxidized layer.
[5] The metal sintered compact according to [4],
   in which, in a case where a metal joined body in which metal-made members are joined to each other by the metal sintered compact is subjected to a lateral shear strength test in accordance with JIS C62137-1-2:2010, a lateral shear strength of the metal joined body is 20 MPa or more.
[6] A method for producing a sintered material, the method including:
   a step of blending a silver carboxylate having a group represented by the formula "-COOAg", a nitrogen-containing compound, and a reducing agent to prepare a silver-containing composition; and
   a step of blending the silver-containing composition and copper particles,
   in which a volume-based 50% cumulative particle diameter of the copper particles, as measured by laser diffraction/scattering particle diameter distribution measurement, is 1 µm or more.
[7] A method for producing a joined body configured to have a conductive first part and a conductive second part joined to each other through a joining section which is a metal sintered compact, the method including:
   a step of heating a sintered material attached to either one or both surfaces of the first part and the second part at a temperature of 60°C or higher without solidification to obtain a heated product of the sintered material; and
   a step of calcining the heated product while bringing the first part and the second part into contact with each other through the heated product interposed between the parts in an atmosphere to join the first part and the second part to each other with the metal sintered compact formed from the heated product,
   in which the sintered material contains silver particles, copper particles, a nitrogen-containing compound, and a reducing agent,
   a primary particle diameter of the silver particles is 200 nm or less, and
   a volume-based 50% cumulative particle diameter of the copper particles, as measured by laser diffraction/scattering particle diameter distribution measurement, is 1 µm or more.
[8] A joined body configured to have a conductive first part and a conductive second part joined to each other through a joining section which is a metal sintered compact,
   in which the metal sintered compact has a silver sintered layer,
   the silver sintered layer contains copper particles,
   a volume-based 50% cumulative particle diameter of the copper particles, as measured by laser diffraction/scattering particle diameter distribution measurement, is 1 µm or more,
   an area of a joint surface of both the first part and the second part is 625 mm² or more,
   the first part and the second part are made of copper, silver, aluminum, gold, or nickel, and
   in a case where the joined body is cut into a small piece having a size of 5 mm × 5 mm, including the first part, the second part, and the joining section, and the small piece is subjected to a lateral shear strength test in accordance with JIS C62137-1-2:2010, a lateral shear strength of the small piece is 18 MPa or more.

### [Advantageous Effects of Invention]

According to the present invention, it is possible to provide a sintered material that contains copper particles and enables conductive parts to be joined to each other by calcining without a need to apply high pressure in an atmosphere.

### [Brief Description of Drawings]

FIG. 1 is a cross-sectional view schematically showing an example of a joined body produced using a sintered material according to an embodiment of the present invention.
FIG. 2 is a cross-sectional view schematically showing an example of a semiconductor device including a metal sintered compact formed using a sintered material according to an embodiment of the present invention as a joining section.
FIG. 3A is a cross-sectional view for schematically describing an example of a method for producing a joined body according to an embodiment of the present invention.
FIG. 3B is a cross-sectional view for schematically describing an example of the method for producing a joined body according to the embodiment of the present invention.
FIG. 3C is a cross-sectional view for schematically describing an example of the method for producing a joined body according to the embodiment of the present invention.
FIG. 3D is a cross-sectional view for schematically describing an example of the method for producing a joined body according to the embodiment of the present invention.
FIG. 4A is a cross-sectional view for schematically describing another example of the method for producing a joined body according to the embodiment of the present invention.
FIG. 4B is a cross-sectional view for schematically describing another example of the method for producing a joined body according to the embodiment of the present invention.
FIG. 4C is a cross-sectional view for schematically describing another example of the method for producing a joined body according to the embodiment of the present invention.
FIG. 4D is a cross-sectional view for schematically describing another example of the method for producing a joined body according to the embodiment of the present invention.
FIG. 5A is a cross-sectional view for schematically describing still another example of the method for producing a joined body according to the embodiment of the present invention.
FIG. 5B is a cross-sectional view for schematically describing still another example of the method for producing a joined body according to the embodiment of the present invention.
FIG. 5C is a cross-sectional view for schematically describing still another example of the method for producing a joined body according to the embodiment of the present invention.
FIG. 5D is a cross-sectional view for schematically describing still another example of the method for producing a joined body according to the embodiment of the present invention.
FIG. 6 shows imaging data acquired in observation of a cross-section of a joined body produced in Example 9 by SEM-EDS.
FIG. 7 shows imaging data acquired in observation of a cross-section of a joined body produced in Example 11 by SEM-EDS.

### [Description of Embodiments]

### ◊ Sintered Material

A sintered material according to an embodiment of the present invention contains silver particles, copper particles, a nitrogen-containing compound, and a reducing agent, in which a primary particle diameter of the silver particles is 200 nm or less, and a volume-based 50% cumulative particle diameter of the copper particles (which may be referred to as a "D50" in the present specification), as measured by laser diffraction/scattering particle diameter distribution measurement, is 1 µm or more.

By incorporating both silver particles having a small primary particle diameter and copper particles having a relatively large D50 into the sintered material of the present embodiment, the formation of an oxidized layer on surfaces of copper particles during the storage and the calcining is suppressed, and the conductive parts (for example, a metal-made member) can be joined to each other with sufficient strength by calcining without a need to apply high pressure in an atmosphere.

### <<Silver Particle>>

The primary particle diameter of the silver particles is 200 nm or less, and may be, for example, any of 150 nm or less, 100 nm or less, and 50 nm or less. By setting the primary particle diameter of the silver particles to 200 nm or less, the conductive parts, which are joining targets, can be joined to each other with sufficient strength by the metal sintered compact (joining section) even without applying high pressure to a laminate obtained using the conductive parts and the sintered material, during the calcination of the sintered material in an atmosphere.

In the present specification, "silver particles" refers to the above-described silver particles having a primary particle diameter of 200 nm or less unless otherwise specified.

A lower limit value of the primary particle diameter of the silver particles is not particularly limited. For example, by setting the primary particle diameter to 1 nm or more, it is easier to produce the metal sintered compact.

An average secondary particle diameter of the silver particles is preferably 2,000 nm or less, and may be, for example, any of 1,500 nm or less, 1,000 nm or less, or 500 nm or less. By setting the average secondary particle diameter of the silver particles to be equal to or less than the upper limit value, the conductive parts, which are joining targets, can be joined to each other with sufficient strength by the metal sintered compact (joining section) even without applying high pressure to a laminate obtained using the conductive parts and the sintered material during the calcination of the sintered material in an atmosphere.

A lower limit value of the average secondary particle diameter of the silver particles is not particularly limited. For example, by setting the average secondary particle diameter to 100 nm or more, the occurrence of cracks in the metal sintered compact is further suppressed.

In the present specification, "average secondary particle diameter of the silver particles" means an average value of the maximum diameters obtained by performing a freeze-fracture of a sintered material, observing a fractured surface of the obtained freeze-fractured product, and dividing a total value of maximum diameters in measurement of the maximum diameters of individual silver particle aggregates in fractured surfaces by the number of measurements of the silver particle aggregates (the number of measurements of the maximum diameter) which will be described later in the examples unless otherwise specified.

The silver particles are preferably formed by a chemical reaction of a silver-containing compound having a silver atom as a constituent atom.

The silver-containing compound may be either of an inorganic compound having a silver atom (inorganic silver compound) and an organic compound having a silver atom (organic silver compound).

The silver-containing compound used in the production of the sintered material may be of only one kind or of two or more kinds, and in the case of using two or more kinds, a combination and a ratio thereof can be adjusted as desired.

Examples of the silver-containing compound include a compound that forms silver by thermal decomposition or reduction thereof.

Examples of such a silver-containing compound include a silver carboxylate (a silver salt of carboxylic acid) having a group represented by the formula "-COOAg".

In a case where the silver particle is formed by the chemical reaction of the silver carboxylate, the sintered material is formed by blending (mixing) a silver-containing composition with the copper particles, and the silver-containing composition is preferably a composition formed by blending (mixing) the silver carboxylate, the nitrogen-containing compound, and the reducing agent. In the silver-containing composition, the silver particles are generated from the silver carboxylate by heat treatment of the composition, an action of the reducing agent, or the like. Furthermore, in a case where the silver-containing composition and the copper particles are blended by adjusting the blending amount (mixing amount) of the silver carboxylate, the nitrogen-containing compound, and the reducing agent, a sintered material containing the silver particles, the copper particles, the nitrogen-containing compound, and the reducing agent can be obtained even without separately blending the nitrogen-containing compound and the reducing agent.

### ∘ Silver-Containing Composition

### <Silver Carboxylate>

The silver carboxylate is not particularly limited as long as it has a group represented by the formula "-COOAg". For example, the number of groups represented by the formula "-COOAg" may be only one or may be two or more. In addition, a position of the group represented by the formula "-COOAg" in the silver carboxylate is not particularly limited.

Examples of the silver carboxylate include silver β-ketocarboxylate having a carbonyl group (-C(=O)-) at the β-position of a group represented by the formula "-COOAg", and silver carboxylates other than silver β-ketocarboxylate.

### [Silver β-Ketocarboxylate (1)]

Examples of the silver β-ketocarboxylate include silver β-ketocarboxylate represented by General Formula (1) (which may be simply referred to as "silver β-ketocarboxylate (1)" in the present specification). 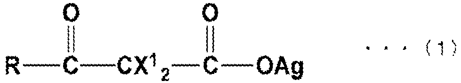
(In the formula, R is an aliphatic hydrocarbon group having 1 to 20 carbon atoms or phenyl group, in which one or more hydrogen atoms may be substituted with a substituent, a hydroxyl group, an amino group, or a group represented by the general formula "R¹-CY¹₂-", "CY¹₃-", "R¹-CHY¹-", "R²O-", "R⁵R⁴N-", "(R³O)₂CY¹-", or "R⁶-C(=O)-CY¹₂-";
Y¹'s are each independently a fluorine atom, a chlorine atom, a bromine atom, or a hydrogen atom; R¹ is an aliphatic hydrocarbon group having 1 to 19 carbon atoms or a phenyl group; R² is a aliphatic hydrocarbon group having 1 to 20 carbon atoms; R³ is an aliphatic hydrocarbon group having 1 to 16 carbon atoms; R⁴ and R⁵ are each independently an aliphatic hydrocarbon group having 1 to 18 carbon atoms; and R⁶ is an aliphatic hydrocarbon group having 1 to 19 carbon atoms, a hydroxyl group, or a group represented by the formula "AgO-";
X¹'s are each independently a hydrogen atom, an aliphatic hydrocarbon group having 1 to 20 carbon atoms, a halogen atom, a phenyl group or benzyl group, in which one or more hydrogen atoms may be substituted with a substituent, a cyano group, an N-phthaloyl-3-aminopropyl group, a 2-ethoxyvinyl group, or a group represented by the general formula "R⁷O-", "R⁷S-", "R⁷-C(=O)-", or "R⁷-C(=O)-O-"; and
R⁷ is an aliphatic hydrocarbon group having 1 to 10 carbon atoms, a thienyl group, or a phenyl group or diphenyl group in which one or more hydrogen atoms may be substituted with a substituent.)

In the formula, R is an aliphatic hydrocarbon group having 1 to 20 carbon atoms or a phenyl group, in which one or more hydrogen atoms may be substituted with a substituent, a hydroxyl group, an amino group, or a group represented by the general formula "R¹-CY¹₂-", "CY¹₃-", "R¹-CHY¹-", "R²O-", "R⁵R⁴N-", "(R³O)₂CY¹-", or "R⁶-C(=O)-CY¹₂-".

The aliphatic hydrocarbon group having 1 to 20 carbon atoms as R may be any of linear, branched, and cyclic forms (aliphatic cyclic group), and in the case of being cyclic, the aliphatic hydrocarbon group may be either monocyclic or polycyclic. In addition, the aliphatic hydrocarbon group may be either of a saturated aliphatic hydrocarbon group and an unsaturated aliphatic hydrocarbon group. The aliphatic hydrocarbon group preferably has 1 to 10 carbon atoms, and more preferably has 1 to 6 carbon atoms. Preferred examples of the aliphatic hydrocarbon group as R include an alkyl group, an alkenyl group, and an alkynyl group.

Examples of the linear or branched alkyl group as R include a methyl group, an ethyl group, an n-propyl group, an isopropyl group, an n-butyl group, an isobutyl group, a sec-butyl group, a tert-butyl group, an n-pentyl group, an isopentyl group, a neopentyl group, a tert-pentyl group, a 1-methylbutyl group, a 2-methylbutyl group, an n-hexyl group, a 1-methylpentyl group, a 2-methylpentyl group, a 3-methylpentyl group, a 4-methylpentyl group, a 1,1-dimethylbutyl group, a 2,2-dimethylbutyl group, a 3,3-dimethylbutyl group, a 2,3-dimethylbutyl group, a 1-ethylbutyl group, a 2-ethylbutyl group, a 3-ethylbutyl group, a 1-ethyl-1-methylpropyl group, an n-heptyl group, a 1-methylhexyl group, a 2-methylhexyl group, a 3-methylhexyl group, a 4-methylhexyl group, a 5-methylhexyl group, a 1,1-dimethylpentyl group, a 2,2-dimethylpentyl group, a 2,3-dimethylpentyl group, 2,4-dimethylpentyl group, a 3,3-dimethylpentyl group, a 4,4-dimethylpentyl group, a 1-ethylpentyl group, a 2-ethylpentyl group, a 3-ethylpentyl group, a 4-ethylpentyl group, a 2,2,3-trimethylbutyl group, a 1-propylbutyl group, an n-octyl group, an isooctyl group, a 1-methylheptyl group, a 2 -methylheptyl group, a 3-methylheptyl group, a 4-methylheptyl group, a 5-methylheptyl group, a 1-ethylhexyl group, a 2-ethylhexyl group, a 3-ethylhexyl group, a 4-ethylhexyl group, a 5-ethylhexyl group, a 1,1-dimethylhexyl group, a 2,2-dimethylhexyl group, a 3,3-dimethylhexyl group, a 4,4-dimethylhexyl group, a 5,5-dimethylhexyl group, a 1,2,3-trimethylpentyl group, a 1,2,4-trimethylpentyl group, a 2,3,4-trimethylpentyl group, a 2,4,4-trimethylpentyl group, a 1,4,4-trimethylpentyl group, a 3,4,4-trimethylpentyl group, a 1,1,2-trimethylpentyl group, a 1,1,3-trimethylpentyl group, a 1,1,4-trimethylpentyl group, a 1,2,2-trimethylpentyl group, a 2,2,3-trimethylpentyl group, a 2,2,4-trimethylpentyl group, a 1,3,3-trimethylpentyl group, a 2,3,3-trimethylpentyl group, a 3,3,4-trimethylpentyl group, a 1-propylpentyl group, a 2-propylpentyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, and an icosyl group.

Examples of the cyclic alkyl group as R include a cyclopropyl group, a cyclobutyl group, a cyclopentyl group, a cyclohexyl group, a cycloheptyl group, a cyclooctyl group, a cyclononyl group, a cyclodecyl group, a norbornyl group, an isobornyl group, a 1-adamantyl group, a 2-adamantyl group, and a tricyclodecyl group.

Examples of the alkenyl group as R include a group in which one single bond (C-C) between the carbon atoms of the alkyl group as R is substituted with a double bond (C=C).

Examples of such an alkenyl group include a vinyl group (ethenyl group, - CH=CH₂), an allyl group (2-propenyl group, -CH₂-CH=CH₂), a 1-propenyl group (-CH=CH-CH₃), an isopropenyl group (-C(CH₃)=CH₂), a 1-butenyl group (-CH=CH-CH₂-CH₃), a 2-butenyl group (-CH₂-CH=CH-CH₃), a 3-butenyl group (-CH₂-CH₂-CH=CH₂), a cyclohexenyl group, and a cyclopentenyl group.

Examples of the alkynyl group as R include a group in which one single bond (C-C) between the carbon atoms of the alkyl group as R is substituted with a triple bond (C=C).

Examples of such an alkynyl group include an ethynyl group (-C=CH) and a propargyl group (-CH₂-C≡CH).

In the aliphatic hydrocarbon group having 1 to 20 carbon atoms as R, one or more hydrogen atoms may be substituted with a substituent. Preferred examples of the substituent include a fluorine atom, a chlorine atom, and a bromine atom. In addition, in the aliphatic hydrocarbon group, the number and the positions of the substituents are not particularly limited. Furthermore, in a case where a plurality of substituents are present, these plurality of substituents may be the same as or different from each other. That is, all the substituents may be the same, all the substituents may be different, or only some of the substituents may be different.

In the phenyl group as R, one or more hydrogen atoms may be substituted with a substituent. Preferred examples of the substituent include a saturated or unsaturated monovalent aliphatic hydrocarbon group having 1 to 16 carbon atoms, a monovalent group in which the aliphatic hydrocarbon group is bonded to an oxygen atom, a fluorine atom, a chlorine atom, a bromine atom, a hydroxyl group (-OH), a cyano group (-C=N), and a phenoxy group (-O-C₆H₅). In the phenyl group having a substituent, the number and the positions of the substituents are not particularly limited. Furthermore, in a case where a plurality of substituents are present, these plurality of substituents may be the same as or different from each other.

Examples of the aliphatic hydrocarbon group as a substituent include the same groups as those for the aliphatic hydrocarbon group as R, except that the number of carbon atoms thereof is 1 to 16.

Y¹'s in R are each independently a fluorine atom, a chlorine atom, a bromine atom, or a hydrogen atom. Furthermore, in the general formula "R¹-CY¹₂-", "CY¹₃-", and "R⁶-C(=O)-CY¹₂-", a plurality of Y¹'s may be the same as or different from each other.

R¹ in R is an aliphatic hydrocarbon group having 1 to 19 carbon atoms or a phenyl group (C₆H₅-). Examples of the aliphatic hydrocarbon group as R¹ include the same groups as those for the aliphatic hydrocarbon group as R, except that the number of carbon atoms thereof is 1 to 19.

R² as R is an aliphatic hydrocarbon group having 1 to 20 carbon atoms, and examples thereof include the same groups as those for the aliphatic hydrocarbon group as R.

R³ in R is an aliphatic hydrocarbon group having 1 to 16 carbon atoms. Examples of the aliphatic hydrocarbon group as R³ include the same groups as those for the aliphatic hydrocarbon group as R, except that the number of carbon atoms thereof is 1 to 16.

R⁴ and R⁵ as R are each independently an aliphatic hydrocarbon group having 1 to 18 carbon atoms. That is, R⁴ and R⁵ may be the same as or different from each other, and examples of the aliphatic hydrocarbon group as R⁴ and R⁵ include the same groups as those for the aliphatic hydrocarbon group as R, except that the number of carbon atoms thereof is 1 to 18.

R⁶ in R is an aliphatic hydrocarbon group having 1 to 19 carbon atoms, a hydroxyl group, or a group represented by the formula "AgO-". Examples of the aliphatic hydrocarbon group as R⁶ include the same groups as those for the aliphatic hydrocarbon group as R, except that the number of carbon atoms thereof is 1 to 19.

Among those, R is preferably the linear or branched alkyl group, the group represented by the general formula "R⁶-C(=O)-CY¹₂-", the hydroxyl group, or the phenyl group. Furthermore, R⁶ is preferably the linear or branched alkyl group, the hydroxyl group, or the group represented by the formula "AgO-".

In General Formula (1), X¹'s are each independently a hydrogen atom, an aliphatic hydrocarbon group having 1 to 20 carbon atoms, a halogen atom, a phenyl group or benzyl group (C₆H₅-CH₂-), in which one or more hydrogen atoms may be substituted with a substituent, a cyano group, an N-phthaloyl-3-aminopropyl group, a 2-ethoxyvinyl group (C₂H₅-O-CH=CH-), or a group represented by the general formula "R⁷O-", "R⁷S-", "R⁷-C(=O)-", or "R⁷-C(=O)-O-".

Examples of the aliphatic hydrocarbon group having 1 to 20 carbon atoms as X¹ include the same groups as those for the aliphatic hydrocarbon group as R.

Examples of the halogen atom of X¹ include a fluorine atom, a chlorine atom, a bromine atom, and an iodine atom.

In the phenyl group and the benzyl group as X¹, one or more hydrogen atoms may be substituted with a substituent. Preferred examples of the substituent include a halogen atom (a fluorine atom, a chlorine atom, a bromine atom, or an iodine atom) and a nitro group (-NO₂). In the phenyl group and the benzyl group having a substituent, the number and the positions of the substituents are not particularly limited. Furthermore, in a case where a plurality of substituents are present, these plurality of substituents may be the same as or different from each other.

R⁷ in X¹ is an aliphatic hydrocarbon group having 1 to 10 carbon atoms, a thienyl group (C₄H₃S-), a phenyl group in which one or more hydrogen atoms may be substituted with a substituent, or a diphenyl group (a biphenyl group or C₆H₅-C₆H₄-). Examples of the aliphatic hydrocarbon group as R⁷ include the same groups as those for the aliphatic hydrocarbon group as R, except that the number of carbon atoms thereof is 1 to 10. In addition, examples of the substituent which the phenyl group and the diphenyl group as R⁷ have include a halogen atom (a fluorine atom, a chlorine atom, a bromine atom, and an iodine atom). In the phenyl group and the diphenyl group, having a substituent, the number and the positions of the substituents are not particularly limited. Furthermore, in a case where a plurality of substituents are present, these plurality of substituents may be the same as or different from each other.

In a case where R⁷ is a thienyl group or a diphenyl group, the bonding position of the group to an adjacent group or atom (an oxygen atom, a sulfur atom, a carbonyl group, or a carbonyloxy group) in X¹ is not particularly limited. For example, the thienyl group may be either of a 2-thienyl group and a 3-thienyl group.

In General Formula (1), two X¹'s may be bonded as one group to the carbon atom interposed between two carbonyl groups through a double bond. Examples of X¹ include a group represented by the formula "=CH-C₆H₄-NO₂".

Among those, X¹ is preferably a hydrogen atom, a linear or branched alkyl group, a benzyl group, or a group represented by the general formula "R⁷-C(=O)-", and it is preferable that at least one X¹ be a hydrogen atom.

The silver β-ketocarboxylate (1) is preferably silver 2-methylacetoacetate (CH₃-C(=O)-CH(CH₃)-C(=O)-OAg), silver acetoacetate (CH₃-C(=O)-CH₂-C(=O)-OAg), silver 2-ethylacetoacetate (CH₃-C(=O)-CH(CH₂CH₃)-C(=O)-OAg), silver propionyl acetate (CH₃CH₂-C(=O)-CH₂-C(=O)-OAg), silver isobutyryl acetate ((CH₃)₂CH-C(=O)-CH₂-C(=O)-OAg), silver pivaloyl acetate ((CH₃)₃C-C(=O)-CH₂-C(=O)-OAg), silver caproyl acetate (CH₃(CH₂)₃CH₂-C(=O)-CH₂-C(=O)-OAg), silver 2-n-butylacetoacetate (CH₃-C(=O)-CH(CH₂CH₂CH₂CH₃)-C(=O)-OAg), silver 2-benzylacetoacetate (CH₃-C(=O)-CH(CH₂C₆H₅)-C(=O)-OAg), silver benzoylacetate (C₆H₅-C(=O)-CH₂-C(=O)-OAg), silver pivaloylacetoacetate ((CH₃)₃C-C(=O)-CH₂-C(=O)-CH₂-C(=O)-OAg), silver isobutyrylacetoacetate ((CH₃)₂CH-C(=O)-CH₂-C(=O)-CH₂-C(=O)-OAg), silver 2-acetylpivaloyl acetate ((CH₃)₃C-C(=O)-CH(-C(=O)-CH₃)-C(=O)-OAg), silver 2-acetylisobutyryl acetate ((CH₃)₂CH-C(=O)-CH(-C(=O)-CH₃)-C(=O)-OAg), or silver acetone dicarboxylate (AgO-C(=O)-CH₂-C(=O)-CH₂-C(=O)-OAg).

The silver β-ketocarboxylate (1) used in the production of the silver-containing composition may be of only one kind or of two or more kinds, and in the case of using two or more kinds, a combination and a ratio thereof can be adjusted as desired.

### [Silver Carboxylate (4)]

Examples of the silver carboxylate other than the silver β-ketocarboxylate include a silver carboxylate represented by General Formula (4) (which may be simply referred to as a "silver carboxylate (4)" in the present specification). 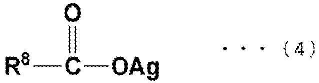 (In the formula, R⁸ is an aliphatic hydrocarbon group having 1 to 19 carbon atoms, a carboxy group, or a group represented by the formula "-C(=O)-OAg", and in a case where the aliphatic hydrocarbon group is a methylene group, one or more of the methylene groups may be substituted with a carbonyl group.)

In the formula, R⁸ is an aliphatic hydrocarbon group having 1 to 19 carbon atoms, a carboxy group (-COOH), or a group represented by the formula "-C(=O)-OAg".

Examples of the aliphatic hydrocarbon group as R⁸ include the same groups as those for the aliphatic hydrocarbon group as R, except that the number of carbon atoms thereof is 1 to 19. It should be noted that the aliphatic hydrocarbon group as R⁸ preferably has 1 to 15 carbon atoms, and more preferably has 1 to 10 carbon atoms.

In a case where the aliphatic hydrocarbon group as R⁸ has a methylene group (-CH₂-), one or more of the methylene groups may be substituted with a carbonyl group. The number and the positions of the methylene groups which may be substituted with the carbonyl group are not particularly limited, and all the methylene groups may be substituted with the carbonyl groups. Here, "methylene group" includes not only a single group represented by the formula "-CH₂-" but also one group represented by the formula "-CH₂-" in an alkylene group in which a plurality of groups represented by the formula "-CH₂-" are linked.

The silver carboxylate (4) is preferably silver pyruvate (CH₃-C(=O)-C(=O)-OAg), silver acetate (CH₃-C(=O)-OAg), silver butyrate (CH₃-(CH₂)₂-C(=O)-OAg), silver isobutyrate ((CH₃)₂CH-C(=O)-OAg), silver 2-ethylhexanoate (CH₃-(CH₂)₃-CH(CH₂CH₃)-C(=O)-OAg), silver neodecanoate, silver oxalate (AgO-C(=O)-C(=O)-OAg), or silver malonate (AgO-C(=O)-CH₂-C(=O)-OAg). In addition, those in which one of the two groups represented by the formula "-COOAg" in the silver oxalate (AgO-C(=O)-C(=O)-OAg) and the silver malonate (AgO-C(=O)-CH₂-C(=O)-OAg) is a group represented by the formula "-COOH" (HO-C(=O)-C(=O)-OAg, HO-C(=O)-CH₂-C(=O)-OAg) are also preferable.

The silver carboxylate (4) used in the production of the silver-containing composition may be of only one kind or of two or more kinds, and in the case of using two or more kinds, a combination and a ratio thereof can be adjusted as desired.

The silver carboxylate used in the production of the silver-containing composition may be of only one kind or of two or more kinds, and in the case of using two or more kinds, a combination and a ratio thereof can be adjusted as desired.

The silver carboxylate is preferably the silver β-ketocarboxylate or the silver oxalate, and more preferably the silver β-ketocarboxylate (1) or the silver oxalate.

That is, the silver particles are preferably ones obtained by thermal decomposition or reduction of the silver β-ketocarboxylate or the silver oxalate, and more preferably ones obtained by thermal decomposition or reduction of the silver β-ketocarboxylate (1) or the silver oxalate.

In the silver-containing composition, a proportion of a total mass of silver derived from the silver carboxylate in the silver-containing composition to a total mass of the silver-containing composition is preferably 50% by mass or more, and more preferably 60% by mass or more. By setting the proportion to be equal to or more than the lower limit value, the conductive parts can be joined to each other with high strength by the metal sintered compact (joining section) even without applying high pressure during the calcination of the sintered material in an atmosphere, as described above. An upper limit value of the proportion is not particularly limited as long as the effect of the present invention is not impaired. For example, a silver-containing composition having the proportion of 85% by mass or less has more favorable handleability.

In the present specification, "silver derived from silver carboxylate" is defined as silver in the silver carboxylate blended in the production of the silver-containing composition unless otherwise specified, and this concept encompasses all of silver continuing to constitute the silver carboxylate even after blending, silver in a decomposition product generated by the decomposition of the silver carboxylate after blending, and silver (silver particles) generated by the thermal decomposition or reduction of the silver carboxylate after blending.

### <Nitrogen-Containing Compound>

Examples of the nitrogen-containing compound include an amine compound having 25 or less carbon atoms.

### <Amine Compound>

The amine compound has 1 to 25 carbon atoms, and may be any of a primary amine, a secondary amine, and a tertiary amine.

The amine compound may be either chain-like or cyclic.

In the amine compound, the number of nitrogen atoms constituting the amine moiety (for example, in the case of a primary amine, a nitrogen atom constituting an amino group (-NH₂)) may be one or may be two or more. In addition, the position of the nitrogen atom constituting the amine moiety in the amine compound is likewise not particularly limited.

Examples of the primary amine include a monoalkylamine, a monoarylamine, a mono(heteroaryl)amine, and a diamine, in which one or more hydrogen atoms may be substituted with a substituent.

The alkyl group constituting the monoalkylamine may be any of linear, branched, and cyclic forms, and examples of such an alkyl group include the same groups as those for the alkyl group as R. The alkyl group is preferably a linear or branched alkyl group having 1 to 19 carbon atoms or a cyclic alkyl group having 3 to 7 carbon atoms.

Specific preferred examples of the monoalkylamine include n-butylamine, n-hexylamine, n-octylamine, n-dodecylamine, n-octadecylamine, isobutylamine, sec-butylamine, tert-butylamine, 3-aminopentane, 3-methylbutylamine, 2-heptylamine (2-aminoheptane), 2-aminooctane, 2-ethylhexylamine, and 1,2-dimethyl-n-propylamine.

Examples of the aryl group constituting the monoarylamine include a phenyl group, a 1-naphthyl group, and a 2-naphthyl group. The number of carbon atoms in the aryl group is preferably 6 to 10.

The heteroaryl group constituting the mono(heteroaryl)amine has a heteroatom as an atom constituting an aromatic ring skeleton, and examples of the heteroatom include a nitrogen atom, a sulfur atom, an oxygen atom, and a boron atom. In addition, the number of the heteroatoms constituting the aromatic ring skeleton is not particularly limited, and may be one or may be two or more. In a case where there are two or more heteroatoms, these heteroatoms may be the same as or different from each other. That is, all of these heteroatoms may be the same, all of these heteroatoms may be different, or only some of the heteroatoms may be different.

The heteroaryl group may be either monocyclic or polycyclic, and the number of ring members (the number of atoms constituting the ring skeleton) is not particularly limited; however, the heteroaryl group is preferably a 3-membered to 12-membered ring.

Examples of the monocyclic groups having 1 to 4 nitrogen atoms among the heteroaryl group include a pyrrolyl group, a pyrrolinyl group, an imidazolyl group, a pyrazolyl group, a pyridyl group, a pyrimidyl group, a pyrazinyl group, a pyridazinyl group, a triazolyl group, a tetrazolyl group, a pyrrolidinyl group, an imidazolidinyl group, a piperidinyl group, a pyrazolidinyl group, and a piperazinyl group, and the heteroaryl group is preferably a 3- to 8-membered ring, and more preferably a 5- or 6-membered ring.

Examples of the heteroaryl group as a monocyclic group having one oxygen atom among the heteroaryl groups include a furanyl group, and such a heteroaryl group is preferably a 3- to 8-membered ring, and more preferably a 5- or 6- membered ring.

Examples of the heteroaryl group as a monocyclic group having one sulfur atom among the heteroaryl groups include a thienyl group, and such a heteroaryl group is preferably a 3- to 8-membered ring, and more preferably a 5- or 6- membered ring.

Examples of the monocyclic heteroaryl group having 1 or 2 oxygen atoms and 1 to 3 nitrogen atoms among the heteroaryl groups include an oxazolyl group, an isoxazolyl group, an oxadiazolyl group, and a morpholinyl group, and such a heteroaryl group is preferably a 3- to 8-membered ring, and more preferably a 5- or 6-membered ring.

Examples of the monocyclic heteroaryl group having 1 or 2 sulfur atoms and 1 to 3 nitrogen atoms among the heteroaryl groups include a thiazolyl group, a thiadiazolyl group, and a thiazolidinyl group, and such a heteroaryl group is preferably a 3- to 8-membered ring, and more preferably a 5- or 6-membered ring.

Examples of the polycyclic heteroaryl group having 1 to 5 nitrogen atoms among the heteroaryl groups include an indolyl group, an isoindolyl group, an indolizinyl group, a benzimidazolyl group, a quinolyl group, an isoquinolyl group, an indazolyl group, a benzotriazolyl group, a tetrazolopyridyl group, a tetrazolopyridazinyl group, and a dihydrotriazolopyridazinyl group, and such a heteroaryl group is preferably a 7- to 12-membered ring, and more preferably a 9- or 10-membered ring.

Examples of the polycyclic heteroaryl group having 1 to 3 sulfur atoms among the heteroaryl groups include a dithianaphthalenyl group and a benzothiophenyl group, where such a heteroaryl group has a 7- to 12-membered ring, and more preferably a 9- or 10-membered ring.

Examples of the polycyclic heteroaryl group having 1 or 2 oxygen atoms and 1 to 3 nitrogen atoms among the heteroaryl groups include a benzoxazolyl group and a benzodiazolyl group, and such a heteroaryl group is preferably a 7- or 12-membered ring, and more preferably a 9- or 10-membered ring.

Examples of the polycyclic heteroaryl group having 1 or 2 sulfur atoms and 1 to 3 nitrogen atoms among the heteroaryl groups include a benzothiazolyl group and a benzothiadiazolyl group, and such a heteroaryl group is preferably a 7- or 12-membered ring, and more preferably a 9- or 10-membered ring.

The diamine may have two amino groups, and a positional relationship between the two amino groups is not particularly limited. Preferred examples of the diamine include the monoalkylamine, the monoarylamine, or the mono(heteroaryl)amine, in which one hydrogen atom other than a hydrogen atom constituting an amino group (-NH₂) is substituted with an amino group.

The diamine preferably has 1 to 10 carbon atoms, and more preferred examples thereof include ethylenediamine, 1,3-diaminopropane, and 1,4-diaminobutane.

Examples of the secondary amine include a dialkylamine, a diarylamine, and a di(heteroaryl)amine, in which one or more hydrogen atoms may be substituted with a substituent.

The alkyl group constituting the dialkylamine is the same as the alkyl group constituting the monoalkylamine, and is preferably a linear or branched alkyl group having 1 to 9 carbon atoms, or a cyclic alkyl group having 3 to 7 carbon atoms. In addition, two alkyl groups in one molecule of the dialkylamine may be the same as or different from each other.

Specific preferred examples of the dialkylamine include N-methyl-n-hexylamine, diisobutylamine, and di(2-ethylhexyl)amine.

The aryl group constituting the diarylamine is the same as the aryl group constituting the monoarylamine, and preferably has 6 to 10 carbon atoms. In addition, two aryl groups in one molecule of the diarylamine may be the same as or different from each other.

The heteroaryl group constituting the di(heteroaryl)amine is the same as the heteroaryl group constituting the mono(heteroaryl)amine, and is preferably a 6- to 12-membered ring. In addition, two heteroaryl groups in one molecule of the di(heteroaryl)amine may be the same as or different from each other.

Examples of the tertiary amine include a trialkylamine and a dialkylmonoarylamine, in which one or more hydrogen atoms may be substituted with a substituent.

The alkyl group constituting the trialkylamine is the same as the alkyl group constituting the monoalkylamine, and is preferably a linear or branched alkyl group having 1 to 19 carbon atoms, or a cyclic alkyl group having 3 to 7 carbon atoms. In addition, three alkyl groups in one molecule of the trialkylamine may be the same as or different from each other. That is, the three alkyl groups may be the same, all of the alkyl groups may be different, or only some of the alkyl groups may be different.

Specific preferred examples of the trialkylamine include N,N-dimethyl-n-octadecylamine and N,N-dimethylcyclohexylamine.

The alkyl group constituting the dialkylmonoarylamine is the same as the alkyl group constituting the monoalkylamine, and is preferably a linear or branched alkyl group having 1 to 6 carbon atoms, or a cyclic alkyl group having 3 to 7 carbon atoms. In addition, two alkyl groups in one molecule of the dialkylmonoarylamine may be the same as or different from each other.

The aryl group constituting the dialkylmonoarylamine is the same as the aryl group constituting the monoarylamine, and preferably has 6 to 10 carbon atoms.

The chain-like amine compound has been mainly described above, but the amine compound may be a heterocyclic compound in which the nitrogen atom constituting the amine moiety is a part of a ring skeleton structure (heterocyclic skeleton structure). That is, the amine compound may be a cyclic amine. The ring (ring including a nitrogen atom constituting the amine moiety) structure at this time may be either monocyclic or polycyclic, the number of ring members (number of atoms constituting the ring skeleton) thereof is not particularly limited, and the ring may be either of an aliphatic ring and an aromatic ring.

Preferred examples of the cyclic amine include pyridine.

In the primary amine, the secondary amine, the tertiary amine, and the quaternary ammonium salt, the "hydrogen atom which may be substituted with a substituent" is a hydrogen atom other than the hydrogen atom bonded to the nitrogen atom constituting the amine moiety. The number of substituents at this time is not particularly limited, and may be one or may be two or more. All the hydrogen atoms may be substituted with substituents. In a case where a plurality of substituents are present, these plurality of substituents may be the same as or different from each other. That is, the plurality of substituents may be the same, all of the substituents may be different, or only some of the substituents may be different. In addition, the position of the substituent is likewise not particularly limited.

Examples of the substituent in the amine compound include an alkyl group, an aryl group, a halogen atom, a cyano group, a nitro group, a hydroxyl group, and a trifluoromethyl group (-CF₃). Here, examples of the halogen atom include a fluorine atom, a chlorine atom, a bromine atom, and an iodine atom.

In a case where the alkyl group constituting the monoalkylamine has a substituent, the alkyl group is preferably a linear or branched alkyl group having 1 to 9 carbon atoms, which has an aryl group as a substituent, or a cyclic alkyl group having 3 to 7 carbon atoms, which has an alkyl group having 1 to 5 carbon atoms as the substituent. Specific examples of such a monoalkylamine having a substituent include 2-phenylethylamine, benzylamine, and 2,3-dimethylcyclohexylamine.

In addition, in the aryl group and the alkyl group which are the substituents, one or more hydrogen atoms may be further substituted with a halogen atom. Examples of such a monoalkylamine having a substituent substituted with a halogen atom include 2-bromobenzylamine. Here, examples of the halogen atom include a fluorine atom, a chlorine atom, a bromine atom, and an iodine atom.

In a case where the aryl group constituting the monoarylamine has a substituent, the aryl group is preferably an aryl group having 6 to 10 carbon atoms, which has a halogen atom as the substituent. Specific examples of such a monoarylamine having a substituent include bromophenylamine. Here, examples of the halogen atom include a fluorine atom, a chlorine atom, a bromine atom, and an iodine atom.

In a case where the alkyl group constituting the dialkylamine has a substituent, the alkyl group is preferably a linear or branched alkyl group having 1 to 9 carbon atoms, which has a hydroxyl group or an aryl group as a substituent, and specific examples of such a dialkylamine having a substituent include diethanolamine and N-methylbenzylamine.

The nitrogen-containing compound used in the production of the silver-containing composition may be of only one kind or of two or more kinds, and in the case of using two or more kinds, a combination and a ratio thereof can be adjusted as desired.

As the amine compound, n-propylamine, n-butylamine, n-hexylamine, n-octylamine, n-dodecylamine, n-octadecylamine, isobutylamine, sec-butylamine, tert-butylamine, 3-aminopentane, 3-methylbutylamine, 2-heptylamine, 2-aminooctane, 2-ethylhexylamine, 2-phenylethylamine, ethylenediamine, 1,3-diaminopropane, 1,4-diaminobutane, N-methyl-n-hexylamine, diisobutylamine, N-methylbenzylamine, di(2-ethylhexyl)amine, 1,2-dimethyl-n-propylamine, N,N-dimethyl-n-octadecylamine, or N,N-dimethylcyclohexylamine is preferable.

In the silver-containing composition, a blending amount of the nitrogen-containing compound is preferably 0.1 to 5 mol, and more preferably 0.1 to 3 mol per mol of the blending amount of the silver carboxylate, and may be, for example, either of 0.2 to 2 mol and 0.2 to 1 mol. By setting the blending amount to be within such a range, the conductive parts can be joined to each other with high strength by the metal sintered compact (joining section) even without applying high pressure during the calcination of the sintered material in an atmosphere, as described above.

### <Reducing Agent>

The reducing agent is not particularly limited.

The reducing agent used in the production of the silver-containing composition may be of only one kind or of two or more kinds, and in the case of using the two or more kinds, a combination and a ratio thereof can be adjusted as desired.

Preferred examples of the reducing agent include formic acid.

In the silver-containing composition, the blending amount of the reducing agent is preferably 0.2 to 5 mol, and more preferably 0.3 to 3 mol per mol of the blending amount of the silver carboxylate, and may be, for example, either of 0.4 to 2 mol and 0.4 to 1 mol. By setting the blending amount to be within such a range, the conductive parts can be joined to each other with high strength by the metal sintered compact (joining section) even without applying high pressure during the calcination of the sintered material in an atmosphere, as described above.

### <Other Components>

Other components that do not correspond to any of the silver carboxylate, the nitrogen-containing compound, and the reducing agent (referred to as "other components (ii)" in the present specification) may be blended in the silver-containing composition.

The other components (other components (ii)) used in the production of the silver-containing composition may be of only one kind or of two or more kinds, and in the case of using the two or more kinds, a combination and a ratio thereof can be adjusted as desired.

### ∘ Method for Producing Silver-Containing Composition

The silver-containing composition can be obtained by blending the silver carboxylate (silver carboxylate having a group represented by the formula "-COOAg"), the nitrogen-containing compound, and the reducing agent. That is, the method for producing the silver-containing composition has a step of blending the silver carboxylate, the nitrogen-containing compound, and the reducing agent to prepare a silver-containing composition.

After blending each of the components, the obtained composition may be used as it is as the silver-containing composition, or a composition obtained by performing a known post-treatment operation or purification operation as necessary may be used as the silver-containing composition.

The blending order of each of the components is not particularly limited. An example of a preferred blending method for each component may be a blending method in which the silver carboxylate is added to and mixed with the nitrogen-containing compound, and then the reducing agent is added to and mixed with the obtained mixture.

In a case where the other components (ii) are blended, it is sufficient for the other components (ii) to be blended at a suitable timing depending on a kind thereof.

The mixing method is not particularly limited, and may be appropriately selected from known methods such as a mixing method including rotating a stirring bar, a stirring blade, or the like; a mixing method using a mixer, a triple roll, a kneader, a bead mill, or the like; a mixing method including applying ultrasonic waves; and the like.

A temperature during the blending of each component is not particularly limited as long as none of the blending components deteriorates, but the temperature is preferably -5°C to 60°C. Furthermore, the temperature during the blending may be appropriately adjusted so that the mixture obtained by the blending has a viscosity that enables the mixture to be easily stirred according to kinds and amounts of the blending components.

In addition, the blending time for each component is not particularly limited as long as none of the blending components deteriorates, but the time is preferably 10 minutes to 36 hours.

By the above-described production method, a silver-containing composition containing silver particles having the above-described primary particle diameter can be obtained. In this case, the primary particle diameter of the silver particles may be adjusted by adjusting, for example, the conditions for producing the silver-containing composition, such as stirring conditions in each step.

According to the above-described production method, a silver-containing composition containing silver particles having the above-described average secondary particle diameter can also be obtained. The average secondary particle diameter of the silver particles can also be adjusted by adjusting the conditions for producing the silver-containing composition, such as stirring conditions in each step.

Regardless of the presence or absence of the use of the silver-containing composition, a proportion of the content of silver particles with respect to a total mass of the sintered material in the sintered material (referred to as "a concentration of silver particles" in the present specification) is preferably 25% to 80% by mass, and may be, for example, 50% to 80% by mass. By setting the proportion (concentration of silver particles) to be within such a range, the conductive parts can be joined to each other with high strength by the metal sintered compact (joining section) even without applying high pressure during the calcination of the sintered material in an atmosphere, as described above.

### <<Copper Particles>>

The shape of the copper particles is not particularly limited. For example, the copper particles may have a spherical shape (spherical particles) or may have a flat shape such as a flake shape (flat particles).

A D50 of the copper particles is 1 µm or more, and may be, for example, any of 1.5 µm or more and 2 µm or more. By setting the D50 of the copper particles to be equal to or more than the lower limit value, a surface area of the copper particles is reduced. Therefore, there is a high effect that the formation of an oxidized layer on surfaces of copper particles during the storage and the calcination of the sintered material is suppressed and conductive parts can be joined to each other with sufficient strength by calcining without a need to apply high pressure to the sintered material in an atmosphere.

In the present specification, "copper particles" means the above-described copper particles having a D50 of 1 µm or more unless otherwise specified.

An upper limit value of the D50 of the copper particles is not particularly limited. For example, in a case where the D50 is 20 µm or less, the production of the metal sintered compact is more easily performed.

Regardless of the presence or absence of the silver-containing composition, the content of the copper particles in the sintered material is preferably 0.3 to 2.5 times by mass, and more preferably 0.5 to 2 times by mass the content of the silver particles. By setting the content of the copper particles to be within such a range, the conductive parts can be joined to each other with high strength by the metal sintered compact (joining section) even without applying high pressure during the calcination of the sintered material in an atmosphere, as described above.

In a case where the silver-containing composition is used, the blending amount of the copper particles in the sintered material is preferably 0.3 to 1.5 times by mass the blending amount of the silver-containing composition, and may be, for example, either of 0.6 to 1.5 times by mass and 0.9 to 1.5 times by mass, or may be either of 0.3 to 1.2 times by mass and 0.3 to 0.9 times by mass.

### <<Other Components>>

The sintered material may contain other components that do not correspond to any of the silver particles, the copper particles, the nitrogen-containing compound, and the reducing agent (referred to as "other components (i)" in the present specification).

The other components (other components (i)) contained in the sintered material may be of only one kind or of two or more kinds, and in the case of using two or more kinds, a combination and a ratio thereof can be adjusted as desired.

The other components (other components (i)) are not particularly limited as long as the effect of the present invention is not impaired, and can be selected as desired depending on the intended purpose. For example, in a case where the silver-containing composition is used, the other components (i) may be the other components (ii) that are the blending components in the silver-containing composition (the other components (ii) in the silver-containing composition may be contained as they are in the sintered material), and may be components that are not the blending components of the silver-containing composition.

Preferred examples of the other components (other components (i)) include a liquid component which has either one or both of an ether bond and a hydroxyl group and is liquid at normal temperature (which may be simply referred to as a "liquid component" in the present specification), an antioxidative compound having a boiling point of 150°C or higher (which may be simply referred to as an "antioxidative compound" in the present specification), and a solvent.

In a case where the sintered material contains the liquid component, the joining strength of the joined body is further increased.

By incorporating the antioxidative compound into the sintered material, the formation of an oxidized layer on a surface of an area composed of copper among a joining section and an object to be joined, such as copper particles inside the joining section, can be suppressed.

In a case where the sintered material contains the solvent, the handleability of the sintered material may be improved.

In the present specification, "normal temperature" means a temperature at which no particular cooling or heating occurs, that is, an ordinary temperature, and examples thereof include a temperature of 15°C to 25°C.

### <Liquid Component>

The liquid component is not particularly limited as long as it has either one or both of an ether bond (-O-) and a hydroxyl group (-OH) and is liquid at normal temperature.

That is, examples of the liquid component include a liquid component having one or two or more ether bonds and no hydroxyl groups (that is, an ether); a liquid component having one or two or more hydroxyl groups and no ether bond (that is, an alcohol); and a liquid component having one or two or more ether bonds and one or two or more hydroxyl groups (that is, an alcohol ether).

### [Ether]

Examples of the ether, which is the liquid component, include diethylene glycol dimethyl ether and triethylene glycol dimethyl ether.

The ether which is the other component (other component (i)), contained in the sintered material, may be of only one kind or of two or more kinds, and in the case of using two or more kinds, a combination and a ratio thereof can be adjusted as desired.

### [Alcohol]

Examples of the alcohol, which is the liquid component, include ethylene glycol (EG), 1,2-hexanediol, 1,6-hexanediol, and 1,8-octanediol.

The alcohol which is the other component (other component (i)), contained in the sintered material, may be of only one kind or of two or more kinds, and in the case of using two or more kinds, a combination and a ratio thereof can be adjusted as desired.

### [Alcohol Ether]

Examples of the alcohol ether which is the liquid component include polyethylene glycol (PEG), diethylene glycol, triethylene glycol, ethylene glycol monoethyl ether, and ethylene glycol monohexyl ether.

The alcohol ether which is the other component (other component (i)), contained in the sintered material, may be of only one kind or of two or more kinds, and in the case of using two or more kinds, a combination and a ratio thereof can be adjusted as desired.

The liquid component which is the other component (other component (i)), contained in the sintered material, is preferably one kind or two or more kinds selected from the group consisting of an ether, an alcohol, and an alcohol ether.

In a case where the liquid component is used, the content of the liquid component in the sintered material is preferably 0.05 to 0.15 times by mass the content of the copper particles, and may be, for example, any of 0.07 to 0.13 times by mass and 0.09 to 0.11 times by mass the content of the copper particles. By setting the content of the liquid component to be within such a range, the above-described joining strength is increased.

### <Antioxidative Compound>

The antioxidative compound which is the other component (other component (i)), contained in the sintered material, is not particularly limited as long as it has a boiling point of 150°C or higher.

Preferred examples of the antioxidative compound include ascorbic acid, tocopherol, catechin, isoflavone, anthocyanin, and ferulic acid.

The antioxidative compound which is the other component (other component (i)), contained in the sintered material, may be of only one kind or of two or more kinds, and in the case of using two or more kinds, a combination and a ratio thereof can be adjusted as desired.

The antioxidative compound which is the other component (other component (i)), contained in the sintered material, is preferably one kind or two or more kinds selected from the group consisting of ascorbic acid, tocopherol, catechin, isoflavone, anthocyanin, and ferulic acid.

In a case where the antioxidative compound is used, the content of the antioxidative compound in the sintered material is preferably 0.005 to 0.015 times by mass the content of the copper particles, and may be, for example, either of 0.007 to 0.013 times by mass and 0.009 to 0.011 times by mass the content of the copper particles. By setting the content of the antioxidative compound to be within such a range, the effect of suppressing the formation of an oxidized layer on a surface of an area composed of copper is enhanced, as described above.

### <Solvent>

The solvent is not particularly limited as long as it is a component which is liquid at normal temperature, corresponds to neither the liquid component (an ether, an alcohol, or an alcohol ether) nor the antioxidative compound, and does not impair the effect of the present invention.

The solvent which is the other component (other component (i)), contained in the sintered material, may be of only one kind or of two or more kinds, and in the case of using two or more kinds, a combination and a ratio thereof can be adjusted as desired.

### <<Example of Sintered Material>>

An example of the preferred sintered material of the present embodiment may be a sintered material containing silver particles, copper particles, a nitrogen-containing compound, and a reducing agent, in which a primary particle diameter of the silver particles is 200 nm or less, a volume-based 50% cumulative particle diameter of the copper particles is 1 µm or more as measured by laser diffraction/scattering particle diameter distribution measurement, and
a content of the copper particles in the sintered material is preferably 0.3 to 2.5 times by mass, and more preferably 0.5 to 2 times by mass a content of the silver particles.

Another example of the preferred sintered material of the present embodiment may be a sintered material containing silver particles, copper particles, a nitrogen-containing compound, a reducing agent, and a liquid component that is liquid at normal temperature, in which a primary particle diameter of the silver particles is 200 nm or less, a volume-based 50% cumulative particle diameter of the copper particles is 1 µm or more as measured by laser diffraction/scattering particle diameter distribution measurement,
the liquid component has either one or both of an ether bond and a hydroxyl group,
a content of the copper particles in the sintered material is preferably 0.3 to 2.5 times by mass, and more preferably 0.5 to 2 times by mass a content of the silver particles, and
a content of the liquid component in the sintered material is any of 0.05 to 0.15 times by mass, 0.07 to 0.13 times by mass, and 0.09 to 0.11 times by mass the content of the copper particles.

In such a sintered material, the liquid component is preferably one kind or two or more kinds selected from the group consisting of an ether, an alcohol, and an alcohol ether.

Still another example of the preferred sintered material of the present embodiment may be a sintered material containing silver particles, copper particles, a nitrogen-containing compound, a reducing agent, a liquid component that is liquid at normal temperature, and an antioxidative compound in which a primary particle diameter of the silver particles is 200 nm or less, a volume-based 50% cumulative particle diameter of the copper particles is 1 µm or more as measured by laser diffraction/scattering particle diameter distribution measurement,
the liquid component has either one or both of an ether bond and a hydroxyl group,
the antioxidative compound has a boiling point of 150°C or higher,
a content of the copper particles in the sintered material is preferably 0.3 to 2.5 times by mass, and more preferably 0.5 to 2 times by mass a content of the silver particles,
a content of the liquid component in the sintered material is any of 0.05 to 0.15 times by mass, 0.07 to 0.13 times by mass, and 0.09 to 0.11 times by mass a content of the copper particles, and
a content of the antioxidative compound in the sintered material is any of 0.005 to 0.015 times by mass, 0.007 to 0.013 times by mass, and 0.009 to 0.011 times by mass the content of the copper particles.

In such a sintered material, the liquid component is preferably one kind or two or more kinds selected from the group consisting of an ether, an alcohol, and an alcohol ether.

In such a sintered material, the antioxidative compound is preferably one kind or two or more kinds selected from the group consisting of ascorbic acid, tocopherol, catechin, isoflavone, anthocyanin, and ferulic acid.

Even still another example of the preferred sintered material of the present embodiment may be a sintered material containing silver particles, copper particles, a nitrogen-containing compound, and a reducing agent, in which a primary particle diameter of the silver particles is 200 nm or less, a volume-based 50% cumulative particle diameter of the copper particles is 1 µm or more as measured by laser diffraction/scattering particle diameter distribution measurement,
the sintered material is formed by blending a silver-containing composition with the copper particles,
the silver-containing composition is formed by blending a silver carboxylate, a nitrogen-containing compound, and a reducing agent,
a blending amount of the nitrogen-containing compound in the silver-containing composition is any of 0.1 to 5 mol, 0.1 to 3 mol, 0.2 to 2 mol, and 0.2 to 1 mol per mol of the blending amount of the silver carboxylate,
a blending amount of the reducing agent in the silver-containing composition is any of 0.2 to 5 mol, 0.3 to 3 mol, 0.4 to 2 mol, and 0.4 to 1 mol per mol of the blending amount of the silver carboxylate, and
a blending amount of the copper particles in the sintered material is any of 0.3 to 1.5 times by mass, 0.6 to 1.5 times by mass, 0.9 to 1.5 times by mass, 0.3 to 1.2 times by mass, and 0.3 to 0.9 times by mass a blending amount of the silver-containing composition.

### ◊ Method for Producing Sintered Material

### <<Production Method (1)>>

The sintered material of the present embodiment can be obtained by, for example, blending the silver particles, the copper particles, the nitrogen-containing compound, the reducing agent, and as necessary, the other components (i) (this production method may be referred to as "production method (1)" in the present specification).

That is, production method (1) has a step of blending the silver particles, the copper particles, the nitrogen-containing compound, the reducing agent, and as necessary, the other components (i), in which a primary particle diameter of the silver particles is 200 nm or less, and a volume-based 50% cumulative particle diameter (D50) of the copper particles, as measured by laser diffraction/scattering particle diameter distribution measurement, is 1 µm or more.

Production method (1) may be the same as the above-described method for producing a silver-containing composition, except that the types of blending components are different.

In a case where the other components (i) are blended, it is sufficient for the other components (i) to be blended at a suitable timing depending on a kind thereof.

In production method (1), after blending each of the components, the obtained composition may be used as it is as the sintered material, or a composition obtained by performing a known post-treatment operation or purification operation as necessary may be used as the sintered material.

In production method (1), the average secondary particle diameter of the silver particles may be adjusted by adjusting the conditions for production of the sintered material, such as stirring conditions in each step during the blending (addition) of each component or after blending all the components.

### <<Production Method (2)>>

In a case where the silver-containing composition is used for the sintered material of the present embodiment, the sintered material can be obtained by blending the silver-containing composition with the copper particles, as described earlier (this production method may be referred to as "production method (2)" in the present specification).

That is, production method (2) has a step of blending the silver carboxylate (silver carboxylate having a group represented by the formula "-COOAg"), a nitrogen-containing compound, and a reducing agent to prepare a silver-containing composition; and a step of blending the silver-containing composition and copper particles, in which a volume-based 50% cumulative particle diameter (D50) of the copper particles, as measured by laser diffraction/scattering particle diameter distribution measurement, is 1 µm or more.

The "step of preparing a silver-containing composition" in production method (2) is the same as the "step of preparing a silver-containing composition" described earlier.

In production method (2), the blending order of each of the components at the time of producing the sintered material is not particularly limited.

A mixing method in the production of the sintered material is not particularly limited, and may be, for example, the same as the above-described mixing method in the production of the silver-containing composition.

In a case where the other components (i) are blended, it is sufficient for the other components (i) to be blended at a suitable timing depending on a kind thereof.

In production method (2), after blending each of the components, the obtained composition may be used as it is as the sintered material, or a composition obtained by performing a known post-treatment operation or purification operation as necessary may be used as the sintered material.

In production method (2), the temperature during the blending of each component in the production of the sintered material is not particularly limited as long as none of the blending components deteriorates, but the temperature is preferably 15°C to 35°C. Furthermore, the temperature during the blending may be appropriately adjusted so that the mixture obtained by the blending has a viscosity that enables the mixture to be easily stirred according to kinds and amounts of the blending components.

The time for blending each of the components is not particularly limited as long as none of the blending components deteriorates, but the time is preferably 10 to 60 minutes.

### ◊ Metal Sintered Compact

The metal sintered compact according to an embodiment of the present invention has a silver sintered layer containing copper particles, in which a volume-based 50% cumulative particle diameter (D50) of the copper particles, as measured by laser diffraction/scattering particle diameter distribution measurement, is 1 µm or more, and surfaces of the copper particles do not have an oxidized layer.

The metal sintered compact of the present embodiment is obtained by calcining the sintered material according to an embodiment of the present invention described above.

The metal sintered compact can be used as a conductive joining section that joins conductive parts to each other. Furthermore, by using the sintered material, the conductive parts can be joined to each other with sufficient strength by the metal sintered compact (joining section) during the calcination of the sintered material in an atmosphere even without applying high pressure to a laminate obtained using the conductive parts and the sintered material.

For example, the metal sintered compact is suitably used as the joining section in the joined body in which the conductive first part and the conductive second part are joined through the joining section which will be described later. In such a joined body, peeling between the first part or the second part and the joining section is suppressed. The metal sintered compact is particularly suitably used as a joining section between an electrode on a substrate and a semiconductor element, and is particularly suitable for configuring a semiconductor device that is expected to operate at a high temperature of 250°C or higher.

The silver sintered layer in the metal sintered compact is formed by sintering the silver particles in the sintered material by calcining the sintered material. Furthermore, by further incorporating the copper particles in addition to the silver particles into the sintered material, the silver sintered layer containing the copper particles is formed. At this time, the formation of an oxidized layer on the surfaces of the copper particles can be suppressed by adjusting the calcining conditions.

Examples of the conductive part such as the conductive first part and the conductive second part include a metal-made part (metal-made member). The metal-made part may be, for example, a metal layer provided on a surface of a semiconductor chip such as a silicon chip or a semiconductor element by a sputtering method or a plating method, or may be a metal layer such as an electrode provided on a resin substrate or a ceramic substrate.

The joining strength of the joined body can be determined by a measured value of the die shear strength of the joined body.

The die shear strength of the joined body can be measured in accordance with JIS C62137-1-2: 2010 (lateral shear strength test, IEC 62137-1-2: 2007).

In the case of measurement of the die shear strength (lateral shear strength), a fractured surface of the joined body occurs at the joining section consisting of the metal sintered compact, and the fractured surface is parallel or substantially parallel to the direction of a force applied to the joined body during the measurement of the die shear strength.

In order to compare joining forces of the joining section consisting of the metal sintered compact according to the die shear strength (lateral shear strength) of the joined body, for example, a joined body (metal joined body) for a test, in which a first part is a copper plate having a size of 10 mm × 10 mm and a thickness of 0.8 mm, a second part is a copper chip having a size of 3 mm × 3 mm and a thickness of 0.8 mm, and the joining section consisting of the metal sintered compact has a size of 3 mm × 3 mm, is used; and the die shear strength of the joined body (metal joined body) for a test may be measured to compare the values.

It should be noted that in the joined body for a test, it is preferable that the entire surface of the copper chip on the joining section side be brought into contact with the joining section, and the entire surface of the joining section on the copper plate side be brought into contact with the copper plate.

The thickness of the joining section consisting of the metal sintered compact in the joined body for a test is preferably 1 to 300 µm, more preferably 10 to 200 µm, and still more preferably 20 to 120 µm. By setting the thickness to be equal to or more than the lower limit value, the copper plate and the copper chip can be more easily joined by the joining section even in a case where the copper plate or the copper chip is warped. By setting the thickness to be equal to or less than the upper limit value, a joining section that is homogeneous and free of voids can be more easily formed.

In the joined body for a test, the die shear strength (lateral shear strength) may be, for example, 9 MPa or more, but is preferably 20 MPa or more, and may be, for example, either of 30 MPa or more and 40 MPa or more.

An upper limit value of the die shear strength is not particularly limited. The die shear strength is preferably 60 MPa or less from the viewpoint that the metal sintered compact can be more easily produced.

The die shear strength may be, for example, any of 9 to 60 MPa, 20 to 60 MPa, 30 to 60 MPa, and 40 to 60 MPa.

The thickness of the metal sintered compact is not particularly limited, and can be selected as desired according to the purpose.

For example, the thickness of the metal sintered compact is preferably 1 µm or more, and may be, for example, any of 10 µm or more, 20 µm or more, 65 µm or more, and 80 µm or more.

On the other hand, the metal sintered compact having a thickness of 400 µm or less can be more easily produced, and the thickness may be either of 300 µm or less and 200 µm or less.

### <<Method for Producing Metal Sintered Compact>>

The metal sintered compact can be produced by heating (calcining) the above-described sintered material according to the embodiment of the present invention to sinter the silver particles in the sintered material.

A temperature rising rate during the heating of the sintered material in the production of the metal sintered compact is not particularly limited, but is preferably 3 to 20°C/min, and may be, for example, 3 to 15°C/min. By setting the temperature rising rate to be within such a range, a metal sintered compact having desired characteristics can be more efficiently produced.

A calcining temperature of the sintered material (a temperature at which the sintered material is sintered) in the production of the metal sintered compact is preferably 360°C or lower, and may be, for example, either of 310°C or lower and 260°C or lower. By setting the calcining temperature to be equal to or lower than the upper limit value, excessive heating can be suppressed and a metal sintered compact having favorable characteristics can be obtained.

The calcining temperature of the sintered material (temperature at which the sintered material is sintered) may be either of 175°C or higher and 190°C or higher; however, the calcining temperature is preferably 240°C or higher, and may be, for example, 290°C or higher. By setting the calcining temperature to be equal to or higher than the lower limit value, a higher-purity metal sintered compact can be obtained.

From the viewpoint of increasing the joining strength of the metal sintered compact (the joining section), regardless of the presence or absence of the liquid component in the sintered material, the calcining temperature of the sintered material (a temperature at which the sintered material is sintered) is preferably 240°C or higher, and may be any of 240°C to 360°C, 240°C to 310°C, and 240°C to 260°C.

From the viewpoint that the effect of suppressing the formation of an oxidized layer on a surface of an area composed of copper in a joining section and an object to be joined, such as copper particles inside the metal sintered compact (the joining section), is further increased, in a case where the sintered material does not contain the antioxidative compound, the calcining temperature of the sintered material (a temperature at which the sintered material is sintered) is preferably 260°C or lower, and may be, for example, any of 175 to 260°C, 190°C to 260°C, and 240°C to 260°C.

For the same reason as described above, in a case where the sintered material contains the antioxidative compound, the calcining temperature (a temperature at which the silver-containing composition is sintered) of the sintered material is preferably 310°C or lower, and may be, for example, any of 175°C to 310°C, 190°C to 310°C, and 240°C to 310°C.

Furthermore, in the present specification, the calcination (sintering) of the sintered material has the same definition as the sintering between the silver particles.

The calcining time of the sintered material (time for sintering the sintered material) in the production of the metal sintered compact is preferably 50 to 180 minutes, and may be, for example, any of 50 to 150 minutes, 90 to 180 minutes, and 90 to 150 minutes. By setting the calcining time (sintering time) to be within such a range, a metal sintered compact having desired characteristics can be more efficiently produced.

During the calcination of the sintered material, a pressure applied to a laminate obtained using the conductive part which is a joining target and the sintered material is preferably less than 5.5 MPa, more preferably 5.2 MPa or less, and still more preferably 3 MPa or less, and may be, for example, 1.5 MPa or less. In addition, the pressure is 0 MPa or more, and it is not necessary to apply pressure to the laminate. In this manner, the conductive parts can be joined to each other with sufficient strength by the metal sintered compact (joining section) without applying high pressure. Furthermore, for example, in a case where fragile members are disposed in a peripheral part of the metal sintered compact, such as a case where the metal sintered compact is used as a joining section between an electrode on a substrate and a semiconductor element, unintentional damage to the members can be suppressed by calcination (sintering) without applying such high pressure.

In the present specification, the pressure applied to a laminate obtained using a conductive part which is a joining target and the sintered material is pressure applied in the same direction as the joining direction between the conductive parts by a metal sintered compact (joining section) formed from the sintered material.

The calcination of the sintered material (the sintering between the silver particles) can be performed in an atmosphere and under normal pressure. In the present embodiment, by using the sintered material, the formation of an oxidized layer on a surface of an area composed of copper among a joining section and an object to be joined, such as copper particles inside the metal sintered compact (joining section), can be suppressed even in a case where the sintered material is calcined in an atmosphere.

Preferred examples of a method for producing the metal sintered compact include a production method including a step of attaching the sintered material to an object on which the metal sintered compact is formed; and a step of forming the metal sintered compact by calcining the sintered material after the attachment at a temperature of 360°C or lower, and a pressure applied to a laminate obtained using the sintered material set to less than 5.5 MPa, 5.2 MPa or less, or 3 MPa or less.

According to the production method, by using the sintered material, conductive parts can be joined to each other with sufficient strength by calcination without a need to apply high pressure to the sintered material in an atmosphere.

In the production of the metal sintered compact, a metal sintered compact may be produced, for example, by heating the sintered material at a temperature of 60°C or higher without solidification to obtain a heated product of the sintered material, and then calcining the heated product, as will be described later in the method for producing a joined body.

In this case, for example, a total time of a heating time (a pre-heating time which will be described later) in the case of obtaining the heated product of the sintered material by heating the sintered material at a temperature of 60°C or higher without solidification and a calcining time in the case of calcining the heated product to obtain a metal sintered compact may be the same as the calcining time of the sintered material described earlier. In addition, the calcining temperature in a case where a metal sintered compact is obtained by calcining the heated product may be the same as the calcining temperature of the sintered material described earlier. Furthermore, in a case where a metal sintered compact is obtained by calcining the heated product, a pressure applied to a laminate of a conductive part, which is a joining target, and the heated product may be the same as the pressure applied to the laminate obtained by using the conductive part and the sintered material during the calcination of the sintered material described earlier. In addition, the heated product may be obtained from the sintered material in an atmosphere, and a metal sintered compact may be obtained from the heated product in an atmosphere.

In the production of the metal sintered compact, the sintered material may be attached to a target place in a target shape and then calcined.

Examples of the method for attaching the sintered material to the target place include known methods such as a printing method and an application method.

Examples of the printing method include a screen printing method, a flexographic printing method, an offset printing method, a dip printing method, an ink jet printing method, a dispenser printing method, a jet dispenser printing method, a gravure printing method, a gravure offset printing method, and a pad printing method.

Examples of the application method include methods using various coaters such as a spin coater, an air knife coater, a curtain coater, a die coater, a blade coater, a roll coater, a gate roll coater, a bar coater, a rod coater, and a gravure coater; a method of using a wire bar and a method of using a coating apparatus such as a slot die.

### <<Joined Body>>

The metal sintered compact is, for example, suitable for use as a substitute for solder, and suitable for a use as a joining section between the conductive parts. The metal sintered compact is suitable as, for example, a joining material for a semiconductor.

That is, examples of a joined body having such a joining section include a conductive joined body which is a metal sintered compact configured by joining a conductive first part (which may be simply referred to as a "first part" in the present specification) and a conductive second part (which may be simply referred to as a "second part" in the present specification) through a joining section, in which the joining section is formed from the sintered material according to an embodiment of the present invention.

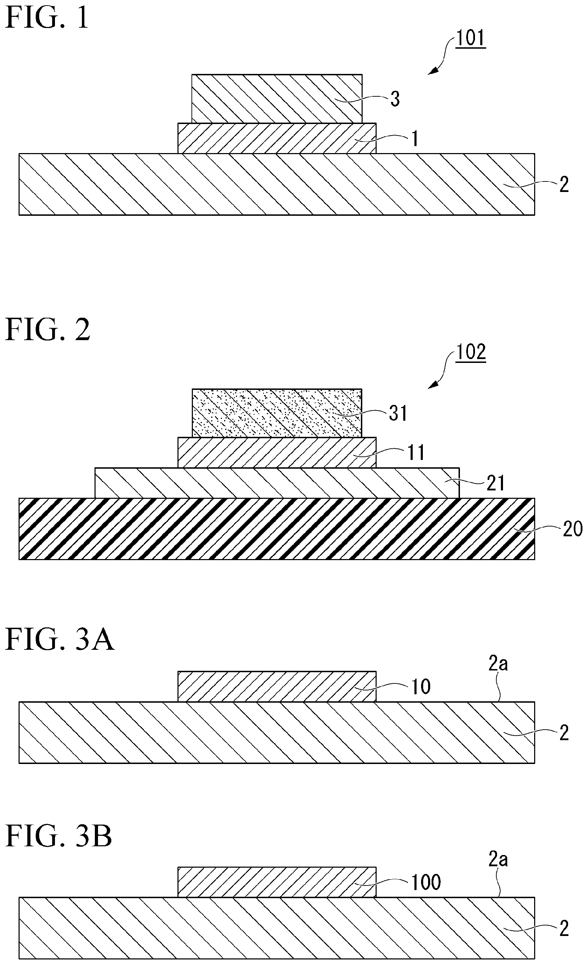

FIG. 1 is a cross-sectional view schematically showing an example of a joined body produced using the sintered material.

A joined body 101 shown herein is configured by joining a conductive first part 2 and a conductive second part 3 to each other through a joining section 1.

The joining section 1 consists of the above-described metal sintered compact according to an embodiment of the present invention.

The first part 2 has a sheet shape, a plate shape, or a block shape.

The first part 2 may consist of one layer (a single layer) or may consist of a plurality of layers including two or more layers. In a case where the first part 2 consists of a plurality of layers, these plurality of layers may be the same as or different from each other, and a combination of these plurality of layers is not particularly limited.

In addition, in the present specification, without being limited to the case of the first part, the expression "the plurality of layers may be the same as or different from one another" means that "all layers may be the same as one another, all layers may be different from one another, or only some layers may be the same as one another" and the expression "the plurality of layers are different from one another" means that "at least one of the constituent materials of each layer and the thicknesses of the layers are different from one another".

In a case where the first part 2 consists of a plurality of layers, for example, one layer or two or more layers of the first part 2 on the joining section 1 side may be layers that improve the adhesiveness to the joining section 1.

The thickness of the first part 2 can be set as desired according to the purpose of the joined body 101 and is not particularly limited.

The thickness of the first part 2 may be, for example, 10 to 10,000 µm.

In a case in which the first part 2 consists of a plurality of layers, a total thickness of the layers may be the above-described preferred thickness of the first part 2.

Here, although the first part 2 has a sheet shape, a plate shape, or a block shape, the first part 2 may have shapes other than these and the shape of the first part 2 can be selected as desired depending on the intended purpose.

The second part 3 has a sheet shape, a plate shape, or a block shape.

The second part 3 may consist of one layer (a single layer) or may consist of a plurality of layers including two or more layers. In a case where the second part 3 consists of a plurality of layers, these plurality of layers may be the same as or different from each other, and a combination of these plurality of layers is not particularly limited.

In a case where the second part 3 consists of a plurality of layers, for example, one layer or two or more layers of the second part 3 on the joining section 1 side may be layers that improve the adhesiveness to the joining section 1.

The thickness of the second part 3 can be set as desired according to the purpose of the joined body 101 and is not particularly limited.

The thickness of the second part 3 is, for example, preferably 0.05 to 10,000 µm, may be 0.05 to 500 µm, or may be more than 500 µm and 10,000 µm or less.

In a case in which the second part 3 consists of a plurality of layers, a total thickness of the layers may be the above-described preferred thickness of the second part 3.

Here, although the second part 3 has a sheet shape, a plate shape, or a block shape, the second part 3 may have shapes other than these and the shape of the second part 3 can be selected as desired depending on the intended purpose.

The joining section 1 consists of the metal sintered compact formed from the sintered material and is conductive, and details thereof are as described earlier.

The joining section 1 has a sheet shape, a plate shape, or a block shape.

The joining section 1 may consist of one layer (a single layer) or may consist of a plurality of layers including two or more layers. In a case where the joining section 1 consists of a plurality of layers, these plurality of layers may be the same as or different from each other, and a combination of these plurality of layers is not particularly limited.

The thickness of the joining section 1 may be the thickness of the metal sintered compact described earlier.

In a case where the joining section 1 consists of a plurality of layers, a total thickness of the layers may be set to be the thickness of the metal sintered compact described earlier.

Here, although the joining section 1 has a sheet shape, a plate shape, or a block shape, the joining section 1 may have shapes other than these shapes, and the shape of the joining section 1 can be selected as desired depending on the intended purpose.

In the joined body 101, one first part 2 and one second part 3 are joined by one joining section 1, but the joining form is not limited thereto.

In the joined body, for example, one first part and two or more second parts may be joined by one joining section. In that case, two or more second parts may be the same, all of the second parts may be different, or only some of the second parts may be different.

In addition, in the joined body, for example, one first part and two or more second parts may be joined by two or more joining sections. In that case, the number of the second parts and the number of the joining sections may be the same as or different from each other. In addition, two or more second parts may be the same, all of the second parts may be different, or only some of the second parts may be different.

The number of the first parts and the number of the second parts exemplified herein may be reversed.

The joined body including the metal sintered compact formed from the sintered material is not limited to that shown in FIG. 1, and for example, some of the configurations may be changed, deleted, or added in the joined body 101 shown in FIG. 1 within a scope not departing from the spirit of the present invention.

Preferred examples of the joined body include a joined body, in which, in a case where a metal joined body in which metal-made members are joined to each other by the metal sintered compact is subjected to a lateral shear strength test in accordance with JIS C62137-1-2:2010, the metal joined body has a lateral shear strength (die shear strength) of 20 MPa or more. The metal-made member and the method for measuring the die shear strength (lateral shear strength) of the joined body is as described earlier.

In the metal joined body, the die shear strength (lateral shear strength) may be, for example, any of 30 MPa or more, and 40 MPa or more.

An upper limit value of the die shear strength is not particularly limited. The die shear strength is preferably 60 MPa or less from the viewpoint that the metal sintered compact can be more easily produced.

The die shear strength may be, for example, any of 20 to 60 MPa, 30 to 60 MPa, and 40 to 60 MPa.

### <Semiconductor Device>

Preferred examples of the joined body include a semiconductor device including a substrate and a semiconductor element joined to the substrate, in which an electrode provided on the substrate and the semiconductor element are joined to each other by a joining section (metal sintered compact), and the joining section is a metal sintered compact formed using the above-described sintered material according to the embodiment of the present invention described above.

FIG. 2 is a cross-sectional view schematically showing an example of the semiconductor device.

The semiconductor device 102 shown herein is configured to include a substrate 20 and a semiconductor element 31 joined to the substrate 20.

An electrode 21 is provided on one surface of the substrate 20, and the electrode 21 and the semiconductor element 31 are joined by a joining section 11.

The joining section 11 consists of a metal sintered compact formed using the sintered material.

The substrate 20 may be, for example, a known substrate such as a resin substrate, and is not particularly limited.

A thickness of the substrate 20 may be, for example, 200 to 10,000 µm.

The electrode 21 may be included in the first part, may be a known electrode such as a metal-made electrode, and is not particularly limited.

A thickness of the electrode 21 may be, for example, 10 to 5,000 µm.

The semiconductor element 31 is included in the second part, and may be a known element such as an element having silicon, silicon carbide, or gallium nitride as a semiconductor-constituting material.

A thickness of the semiconductor element 31 may be, for example, 50 to 800 µm.

The joining section 11 is conductive, and details thereof are as described earlier.

A thickness of the joining section 11 may be, for example, 10 to 200 µm.

The joining form between the electrode 21 and the semiconductor element 31 through the joining section 11 in the joined body 102 may be the same as the joining form between the first part 2 and the second part 3 through the joining section 1 in the joined body 101.

### 0 Method for Producing Joined Body

The joined body can be produced by, for example, a production method including a step of heating the sintered material attached to surfaces of one or both of the first part and the second part without solidification at a temperature of 60°C or higher to obtain a heated product of the sintered material (which may be referred to as a "pre-heating step" in the present specification); and a step of calcining the heated product while bringing the first part into contact with the second part through the heated product interposed between the parts in an atmosphere to join the first part and the second part to each other by a metal sintered compact formed from the heated product (which may be referred to as a "joining step" in the present specification).

That is, in the method for producing a joined body according to an embodiment of the present invention, the joined body is configured to have a conductive first part and a conductive second part joined to each other through a joining section which is a metal sintered compact, and the method includes a step of heating a sintered material attached to one or both surfaces of the first part and the second part at a temperature of 60°C or higher without solidification to obtain a heated product of the sintered material, and a step of calcining the heated product while bringing the first part and the second part into contact with each other through the heated product interposed between the parts in an atmosphere to join the first part and the second part to each other by the metal sintered compact formed from the heated product, in which the sintered material contains silver particles, copper particles, a nitrogen-containing compound, and a reducing agent, a primary particle diameter of the silver particles is 200 nm or less, and a volume-based 50% cumulative particle diameter (D50) of the copper particles, as measured by laser diffraction/scattering particle diameter distribution measurement, is 1 µm or more.

A method for attaching the silver-containing composition to one or both surfaces of the first part and the second part is the same as the method for attaching the sintered material to a target place described earlier.

In the production method of the present embodiment, the pre-heating step is performed because it significantly increases the joining strength of the metal sintered compact (that is, the joining section).

The pre-heating step is not performed in a state where the first part and the second part are in contact with each other (integrated) while the sintered material under heating is interposed between the parts.

The heating temperature of the sintered material in the pre-heating step (which may be simply referred to as a "pre-heating temperature" in the present specification) may be, for example, any of 65°C or higher, 70°C or higher, and 75°C or higher.

An upper limit value of the heating temperature (pre-heating temperature) of the sintered material in the pre-heating step is not particularly limited. For example, the heating temperature is preferably 120°C or lower from the viewpoint that solidification of the sintered material can be easily avoided.

In the pre-heating step, the time for heating the sintered material at a temperature of 60°C or higher without solidification (which may be simply referred to as a "pre-heating time" in the present specification) is preferably 0.1 to 30 minutes, and may be, for example, any of 0.5 to 10 minutes, 1.5 to 10 minutes, and 3 to 10 minutes. By setting the pre-heating time to be within such a range, a desired heated product can be more efficiently produced.

The heated product obtained in the pre-heating step typically does not have gloss peculiar to silver, and based on such external characteristics, the heated product can be distinguished from a target metal sintered compact.

The temperature rising rate during the calcination of the heated product in the joining step may be, for example, the same as the temperature rising rate during the heating of the sintered material in the production of the metal sintered compact described earlier.

In the joining step, the calcining temperature (the calcining temperature between the silver particles) during the calcination of the heated product may be, for example, the same as the calcining temperature of the sintered material (the temperature at which the sintered material is sintered) in the production of the metal sintered compact described earlier.

In the present embodiment, a total time of the calcining time (the sintering time between the silver particles) during the calcination of the heated product and the pre-heating time in the joining step may be, for example, the same as the calcining time of the sintered material (the time for which the sintered material is sintered) in the production of the metal sintered compact described earlier.

In the joining step, in the same manner as in the case of the method for producing a metal sintered compact described earlier, the calcination of the heated product of the sintered material (the sintering between the silver particles) is performed without applying a high pressure to a laminate of the conductive part that is a joining target, and the heated product in an atmosphere. By performing the calcining (sintering) without applying a high pressure in this manner, a high pressure is not applied to the first part and the second part, and unintended damage to the first part and the second part can be suppressed.

FIGS. 3A to 3D are each a cross-sectional view for schematically explaining an example of the production method of the present embodiment.

In the views starting with FIG. 3A, the same components as those shown in the previously explained diagrams are denoted by the same reference numerals as in the previously explained diagrams and detailed description thereof will not be repeated.

FIGS. 3A to 3D each show a case where the sintered material is attached only to a surface of the first part and the pre-heating step is performed to produce the joined body 101 shown in FIG. 1.

That is, in this case, in the pre-heating step, the sintered material 10 attached to one surface 2a of the conductive first part 2 is heated at a temperature of 60°C or higher without solidification, as shown in FIG. 3A, to obtain a heated product 100 of the sintered material, as shown in FIG. 3B.

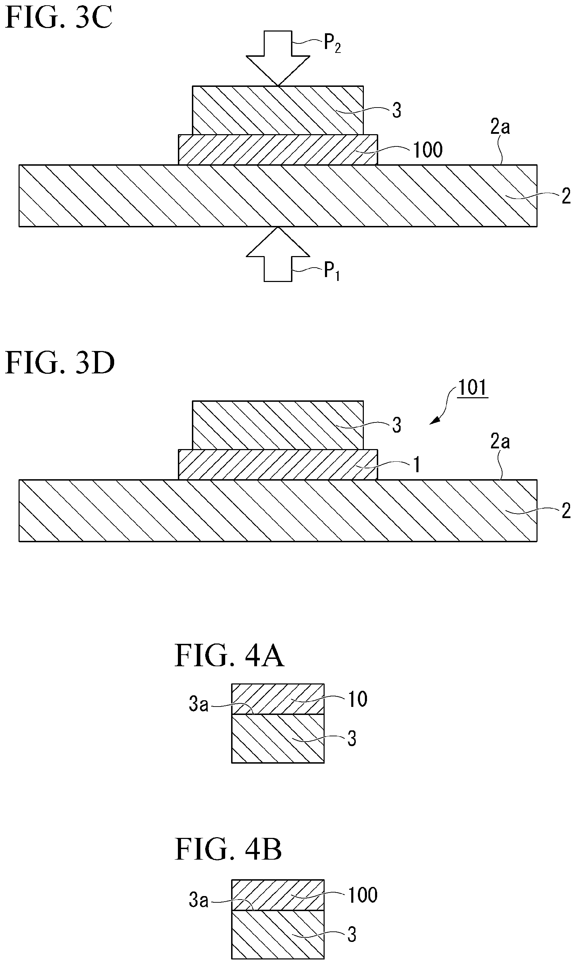

Next, in the joining step, the heated product 100 is calcined in an atmosphere while the first part 2 and the second part 3 are brought into contact with each other through the heated product 100 interposed between the parts, as shown in FIG. 3C. At this time, a pressure applied to the laminate of the first part 2, the second part 3, and the heated product 100 may be either one or both of a pressure P₁ applied from the first part 2 side and a pressure P₂ applied from the second part 3 side, but in either case, the first part 2 and the second part 3 can be joined to each other with sufficient strength without applying high pressure to the laminate, as described earlier. Furthermore, by calcining the heated product 100 in this manner, the first part 2 and the second part 3 are joined to each other by a joining section (metal sintered compact) 1 formed from the heated product 100, as shown in FIG. 3D.

Thus, a joined body 101 shown in FIG. 1 is obtained.

FIGS. 4A to 4D are each a cross-sectional view for schematically explaining another example of the production method of the present embodiment.

FIGS. 4A to 4D each show a case where the sintered material is attached only to a surface of the second part and the pre-heating step is performed to produce a joined body 103 having the same configuration as the joined body 101 shown in FIG. 1.

That is, in this case, in the pre-heating step, the sintered material 10 attached to one surface 3a of the conductive second part 3 is heated at a temperature of 60°C or higher without solidification, as shown in FIG. 4A, to obtain a heated product 100 of the sintered material, as shown in FIG. 4B.

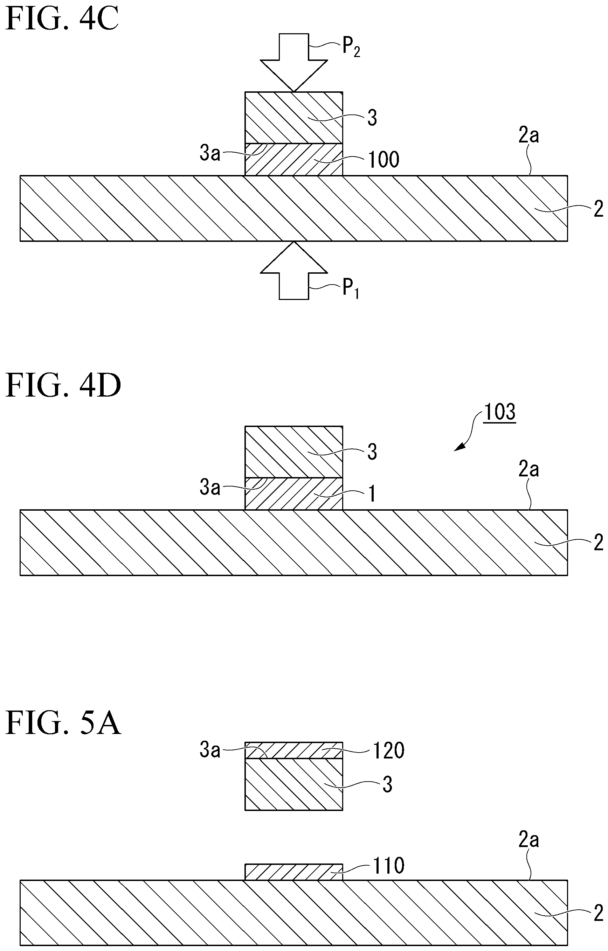

Next, in the joining step, the heated product 100 is calcined in an atmosphere while the first part 2 and the second part 3 are brought into contact with each other through the heated product 100 interposed between the parts, as shown in FIG. 4C. At this time, a pressure applied to the laminate of the first part 2, the second part 3, and the heated product 100 may be either one or both of a pressure P₁ applied from the first part 2 side and a pressure P₂ applied from the second part 3 side, but in either case, the first part 2 and the second part 3 can be joined to each other with sufficient strength without applying high pressure to the laminate, as described earlier. Furthermore, by calcining the heated product 100 in this manner, the first part 2 and the second part 3 are joined to each other by a joining section (metal sintered compact) 1 formed from the heated product 100, as shown in FIG. 4D.

Thus, a joined body 103 is obtained. The joined body 103 is the same as the joined body 101 shown in FIG. 1, except that the size of the joining section (metal sintered compact) 1 is different.

FIGS. 5A to 5D are each a cross-sectional view for schematically explaining still another example of the production method of the present embodiment.

FIGS. 5A to 5D each show a case where the sintered material is attached to both surfaces of the first part and the second part, and the pre-heating step is performed to produce a joined body 104 having the same configuration as the joined body 101 shown in FIG. 1.

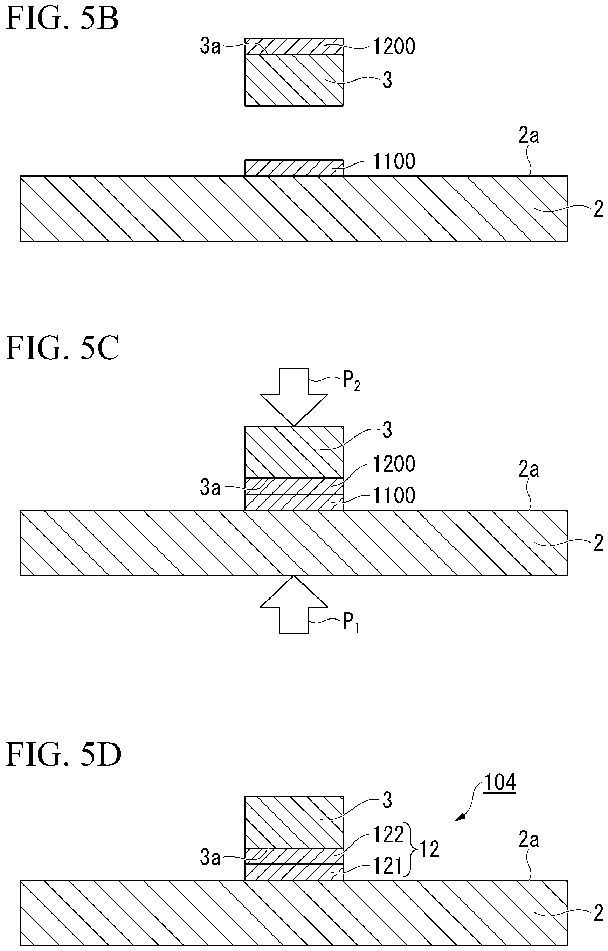

That is, in this case, in the pre-heating step, a first sintered material 110 attached to one surface 2a of the conductive first part 2 and a second sintered material 120 attached to one surface 3a of the conductive second part 3 are each heated at a temperature of 60°C or higher without solidification, as shown in FIG. 5A. Accordingly, a first heated product 1100 which is a heated product is obtained from the first sintered material 110, as shown in FIG. 5B, and the second heated product 1200 which is a heated product is obtained from the second sintered material 120. The first sintered material 110 and the second sintered material 120 may be the same as or different from each other.

Next, in the joining step, as shown in FIG. 5C, the first heated product 1100 and the second heated product 1200 are brought into contact with each other, and the first part 2 and the second part 3 are brought into contact with each other through the first heated product 1100 and the second heated product 1200 interposed between the parts in an atmosphere to calcine the first heated product 1100 and the second heated product 1200. At this time, a pressure applied to a laminate of the first part 2, the second part 3, the first heated product 1100, and the second heated product 1200 can be either one or both of a pressure P₁ applied from the first part 2 side and a pressure P₂ applied from the second part 3 side. Furthermore, in either case, the first part 2 and the second part 3 can be joined to each other with sufficient strength even without applying high pressure to the laminate, as described earlier. Moreover, by calcining the first heated product 1100 and the second heated product 1200 in this manner, the first part 2 and the second part 3 are joined to each other by a joining section (metal sintered compact) 12 formed from the first heated product 1100 and the second heated product 1200, as shown in FIG. 5D. As shown herein, the joining section 12 may be recognized as a two-layer structure with a first joining section (first metal sintered compact) 121 formed from the first heated product 1100 and a second joining section (second metal sintered compact) 122 formed from the second heated product 1200, or may not be recognized as such a two-layer structure, but may be recognized as a single-layer structure as shown in FIG. 4D.

Thus, a joined body 104 which is the same as shown in FIG. 4D is obtained.

### <Method for Producing Semiconductor Device>

The semiconductor device in the joined body can be produced by using an electrode as the first part and using a semiconductor element as the second part in the above-described method for producing a joined body.

### 0 Joined Body

A joined body according to an embodiment of the present invention is configured to have a conductive first part and a conductive second part joined to each other through a joining section which is a metal sintered compact, in which the metal sintered compact has a silver sintered layer, the silver sintered layer contains copper particles, a volume-based 50% cumulative particle diameter of the copper particles, as measured by laser diffraction/scattering particle diameter distribution measurement, is 1 µm or more, an area of a joint surface of both the first part and the second part is 625 mm² or more, the first part and the second part are made of copper, silver, aluminum, gold, or nickel, and in a case where the joined body is cut into a small piece having a size of 5 mm × 5 mm, including the first part, the second part, and the joining section, and the small piece is subjected to a lateral shear strength test in accordance with JIS C62137-1-2:2010, a lateral shear strength of the small piece is 18 MPa or more (the joined body may be referred to as a "joined body (Z)" in the present specification).

The joined body of the present embodiment (joined body (Z)) is the joined body that can be produced by the above-described method for producing a joined body according to an embodiment of the present invention with the following modifications: an area of a joint surface of both a first part and a second part is limited to 625 mm² or more, the first part and the second part are limited to parts made of copper, silver, aluminum, gold, or nickel, and a lateral shear strength (die shear strength) of the small piece cut out from the joined body of the present embodiment (joined body (Z)) is 18 MPa or more. That is, the joined body (Z) is the same as the joined body that can be produced in the above-described method for producing a joined body according to the embodiment of the present invention, except that those modifications are not made.

For example, in the joined body (Z), the copper particles preferably do not have an oxidized layer on surfaces thereof.

The small piece is also a joined body according to an embodiment of the present invention described earlier.

Without being limited to the case of the joined body (Z), the joint surface of the first part in the joined body is a surface of the first part on the joining section side, and the joint surface of the second part in the joined body is a surface of the second part on the joining section side.

In the joined body (Z), the combination of the first part and the second part is a combination of copper-made parts, a combination of silver-made parts, a combination of aluminum-made parts, a combination of gold-made parts, a combination of nickel-made parts, a combination of a copper-made part and a silver-made part, a combination of a copper-made part and an aluminum-made part, a combination of a copper-made part and a gold-made part, a combination of a copper-made part and a nickel-made part, a combination of a silver-made part and an aluminum-made part, a combination of a silver-made part and a gold-made part, a combination of a silver-made part and a nickel-made part, a combination of an aluminum-made part and a gold-made part, a combination of an aluminum-made part and a nickel-made part, or a combination of a gold-made part and a nickel-made part.

In a case where the small piece is viewed in a plan view by looking down from above on the first part or second part side in the small piece, the planar shape of the small piece is a square and the size of the square is 5 mm × 5 mm.

In the joined body (Z), it is preferable that the die shear strength (lateral shear strength) of the small pieces in 30% or more of the maximum number that can be produced be 18 MPa or more, and it is more preferable that the die shear strength of the small pieces in the maximum number that can be produced be 18 MPa or more.

The planar shape of the joint surfaces of both the first part and the second part is preferably a quadrangular shape, and may be a square shape.

The area of the joint surface of both the first part and the second part may be, for example, any of 675 mm² or more, 725 mm² or more, 780 mm² or more, and 840 mm² or more.

From the viewpoint of making it easier to produce the joined body (Z), the area of the joint surface may be, for example, 1,225 mm² or less.

The area of the joint surface may be, for example, any of 625 to 1,225 mm², 675 to 1,225 mm², 725 to 1,225 mm², 780 mm² to 1,225 mm², and 840 to 1,225 mm².

The die shear strength (lateral shear strength) of the small piece may be either of 30 MPa or more and 40 MPa or more.

An upper limit value of the die shear strength of the small piece is not particularly limited. The die shear strength of the small piece is preferably 60 MPa or less from the viewpoint that a metal sintered compact can be more easily produced.

The die shear strength of the small piece may be, for example, any of 18 to 60 MPa, 30 to 60 MPa, and 40 to 60 MPa.

The die shear strength (lateral shear strength) of the small piece can be measured by the same method as in the above-described case of the die shear strength (lateral shear strength) of the joined body for a test.

### [Examples]

Hereinafter, the present invention will be described in more detail with reference to specific examples. However, the present invention is not limited to these examples.

### [Example 1]

### <<Production of Sintered Material>>

### <Production of Silver-Containing Composition>

2-Ethylhexylamine (0.4-fold molar amount with respect to silver 2-methylacetoacetate which will be described later) was added to a beaker, silver 2-methylacetoacetate (52.9 g) was added thereto so that a liquid temperature thereof reached 40°C or lower, and the obtained mixture was stirred with a mechanical stirrer for 15 minutes.

Next, formic acid (0.65-fold molar amount with respect to silver 2-methylacetoacetate) was added dropwise to the obtained stirring solution over 10 minutes so that a liquid temperature thereof reached 60°C or lower, and the obtained mixture was further stirred at 26°C for 1.5 hours.

Thus, a silver-containing composition (A) was obtained.

As a result of analyzing the obtained silver-containing composition (A) by gas chromatography, it could be confirmed that the silver-containing composition (A) contained 2-ethylhexylamine and formic acid. In addition, it could also be confirmed that the silver-containing composition (A) contained silver particles. A proportion of a total mass of silver derived from silver 2-methylacetoacetate in the silver-containing composition (A) to a total mass of the silver-containing composition (A) was 63% by mass.

### <Production of Sintered Material>

The silver-containing composition (A) (10 parts by mass) obtained above and copper particles (a) (manufactured by Fukuda Metal Foil & Powder Co., Ltd., CU-HWQ Grade 1.5 µm, D50: 1 to 2 µm, tap density: 3 to 4 g/cm³, spherical) (10 parts by mass) were mixed and stirred for 5 minutes at normal temperature to obtain a sintered material.

The sintered material obtained above was cooled and freeze-fractured, and a fractured surface of the freeze-fractured product was observed using a scanning electron microscope (SEM, "Cryo FIC-SEM FEI, Helios NanoLab 600") under the condition of an accelerating voltage of 1 kV (reflected electron image). Then, the silver particle aggregates were identified by performing image processing on the SEM image with a magnification of 10,000 times using image analysis software ("Image J."). From the identification result, the maximum diameter of each silver particle aggregate was measured. The number of measurements of the silver particle aggregates was set to 700 or more. Here, "maximum diameter" means a maximum value of the length of a line segment connecting any two points located on the contour line in the identified image of the silver particle aggregate. As a result, an average value of the maximum diameters, that is, an average secondary particle diameter, of the silver particles was 294 nm.

As a result of observing the fractured surface of the freeze-fractured product using a transmission electron microscope (TEM), each silver particle aggregate was composed of silver particles having a primary particle diameter of 200 nm or less. A proportion (a concentration of the silver particles) of a content of the silver particles in the sintered material to the total mass of the sintered material was 30% by mass.

### <<Production of Joined Body (Metal Sintered Compact)>>

A copper plate having a size of 10 mm × 10 mm and a thickness of 0.8 mm, and a copper chip having a size of 3 mm × 3 mm and a thickness of 0.8 mm and having a square planar shape were prepared.

A printing layer having a size of 3 mm × 3 mm and a thickness of 0.1 mm of the sintered material obtained above was formed on one surface of the copper plate by a screen printing method.

Next, the printing layer was pre-heated at 80°C for 2 minutes under the conditions of no pressure (under normal pressure) in an atmosphere, using Program Hot Plate (manufactured by AS ONE Corporation), and then the copper chip was placed on the heated product (pre-heated product) of the printing layer. At this time, in a plan view from above, the center of the heated product and the center of the copper chip were matched. Further, the copper chip was arranged so that the outer circumference of the heated product and the outer circumference of the copper chip were parallel to each other.

Next, the obtained laminate was subjected to a temperature rise from room temperature to 120°C at a temperature rising rate of 5°C/min while applying a pressure of 1 MPa to the laminate in a thickness direction thereof, and held at 120°C for 5 minutes as it was; subjected to a temperature rise from 120°C to 190°C at a temperature rising rate of 5°C/min and held at 190°C for 5 minutes as it was; and subjected to a temperature rise from 190°C to 200°C at a temperature rising rate of 5°C/min and held at 200°C for 60 minutes as it was in an atmosphere to calcine the heated product. During this time, until the laminate was subjected to a temperature rise from room temperature, and until the laminate was held at 200°C for 60 minutes, the above-described pressure of 1 MPa was continuously applied to the laminate. Thus, a metal sintered compact having a size of 3 mm × 3 mm was formed from the heated product.

Next, the obtained calcined product was allowed to be cooled to room temperature.

Thus, a joined body configured by joining the copper plate and the copper chip to each other through the joining section formed from the metal sintered compact was obtained.

### «Evaluation of Joined Body (Metal Sintered Compact)»

### <Measurement of Die Shear Strength>

For the joined body obtained above, a die shear strength was measured in accordance with JIS C62137-1-2:2010 (lateral shear strength test, IEC62137-1-2:2007) using a tester ("Bond Tester 4000" manufactured by Dage). More specifically, the joined body was fractured using a shear tool of the tester, and a maximum load during the fracture was measured. This measured value was divided by an area of the joint place in the joined body (that is, 3 mm × 3 mm), and the obtained value was adopted as the die shear strength of the joined body. Then, a case where the die shear strength of the joined body was 40 MPa or more was determined as "A", a case where the die shear strength was 20 MPa or more and less than 40 MPa was determined as "B", a case where the die shear strength was more than 0 MPa and less than 20 MPa was determined as "C", and a case where there was no joining at all (the die shear strength was 0 MPa) was determined as "D". The results are shown in Table 1 together with the calculated values of the die shear strength.

In Table 1, "Pressure (MPa) during calcining" means a pressure applied to the laminate. In addition, "Final calcining temperature" means a calcining temperature in the final stage, which is a main calcining temperature during the calcination of the heated product. Furthermore, "Final calcining time" means a calcining time at the final calcining temperature during the calcination of the heated product. These apply to the subsequent examples and comparative examples.

### <Confirmation of Presence or Absence of Oxidized Layer>

The cross-sections in the three joined bodies obtained above were prepared using an ion milling device ("IM4000PLUS" manufactured by Hitachi High-Tech Corporation), and the cross-sections were observed by energy dispersive X-ray spectroscopy (EDS) performed in a scanning electron microscope (SEM) (SEM-EDS) and energy dispersive X-ray spectroscopy (EDS) performed in a transmission electron microscope (TEM) (TEM-EDS). Then, the presence or absence of oxygen (in other words, an oxidized layer) on surfaces of the copper particles inside the joining section and a surface of the copper plate was confirmed. The results are shown in Table 1.

A thickness of the metal sintered compact was measured at the same time as the confirmation of the presence or absence of an oxidized layer in three joined bodies of which the cross-sections had been prepared, and a range of the thickness from the minimum value and the maximum value thereof was 15 to 50 µm. Therefore, in the joined bodies obtained above, the thickness of the metal sintered compact was presumed to be in a range of 15 to 50 µm.

<<Production of Sintered Material, Production of Joined Body (Metal Sintered Compact), and Evaluation of Joined Body (Metal Sintered Compact)>>

### [Example 2]

A sintered material and a joined body (metal sintered compact) were produced by the same method as in the case of Example 1, except that during the formation of the metal sintered compact, the laminate was finally subjected to a temperature rise to 250°C and held at 250°C for 60 minutes as it was, instead of subjecting the laminate to a temperature rise to 200°C and holding it at 200°C for 60 minutes as it was. The joined body (metal sintered compact) was evaluated. The results are shown in Table 1.

### [Example 3]

A sintered material and a joined body (metal sintered compact) were produced by the same method as in the case of Example 1, except that during the formation of the metal sintered compact, the laminate was finally subjected to a temperature rise to 300°C and held at 300°C for 60 minutes as it was, instead of subjecting the laminate to a temperature rise to 200°C and holding it at 200°C for 60 minutes as it was. The joined body (metal sintered compact) was evaluated. The results are shown in Table 1.

### [Example 4]

### <<Production of Sintered Material>>

The silver-containing composition (A) was obtained by the same method as in Example 1.

The silver-containing composition (A) (10 parts by mass) obtained above, copper particles (a) (manufactured by Fukuda Metal Foil & Powder Co., Ltd., CU-HWQ Grade 1.5 µm, D50: 1 to 2 µm, tap density: 3 to 4 g/cm³, spherical) (10 parts by mass), and polyethylene glycol 300 (PEG300 manufactured by Fujifilm Wako Pure Chemical Corporation) (1 part by mass) were mixed and stirred at normal temperature to obtain a sintered material.

The sintered material obtained above was cooled and freeze-fractured, and the fractured surface of the freeze-fractured product was observed by the same method as in the case of Example 1. As a result, an average secondary particle diameter of the silver particles was 294 nm, and each silver particle aggregate was composed of silver particles having a primary particle diameter of 200 nm or less. A proportion (a concentration of the silver particles) of a content of the silver particles in the sintered material to the total mass of the sintered material was 30% by mass.

### <<Production and Evaluation of Joined Body (Metal Sintered Compact)>>

A joined body (metal sintered compact) was produced and evaluated by the same method as in the case of Example 1, except that the sintered material obtained above was used. The results are shown in Table 1.

### <<Production of Sintered Material, Production of Joined Body (Metal Sintered Compact), and Evaluation of Joined Body (Metal Sintered Compact)>>

### [Example 5]

A sintered material and a joined body (metal sintered compact) were produced by the same method as in the case of Example 4, except that during the formation of the metal sintered compact, the laminate was finally subjected to a temperature rise to 250°C and held at 250°C for 60 minutes as it was, instead of subjecting the laminate to a temperature rise to 200°C and holding it at 200°C for 60 minutes as it was. The joined body (metal sintered compact) was evaluated. The results are shown in Table 1.

### [Example 6]

A sintered material and a joined body (metal sintered compact) were produced by the same method as in the case of Example 4, except that during the formation of the metal sintered compact, the laminate was finally subjected to a temperature rise to 300°C and held at 300°C for 60 minutes as it was, instead of subjecting the laminate to a temperature rise to 200°C and holding it at 200°C for 60 minutes as it was. The joined body (metal sintered compact) was evaluated. The results are shown in Table 1.

### [Example 7]

### <<Production of Sintered Material>>

The silver-containing composition (A) was obtained by the same method as in Example 1.

The silver-containing composition (A) (10 parts by mass) obtained above, copper particles (a) (manufactured by Fukuda Metal Foil & Powder Co., Ltd., CU-HWQ Grade 1.5 µm, D50: 1 to 2 µm, tap density: 3 to 4 g/cm³, spherical) (10 parts by mass), polyethylene glycol 300 (PEG300 manufactured by Fujifilm Wako Pure Chemical Corporation) (1 part by mass), and ascorbic acid (manufactured by FUJIFILM Wako Pure Chemical Corporation) (0.1 parts by mass) were mixed and stirred at normal temperature to obtain a sintered material.

The sintered material obtained above was cooled and freeze-fractured, and the fractured surface of the freeze-fractured product was observed by the same method as in the case of Example 1. As a result, an average secondary particle diameter of the silver particles was 294 nm, and each silver particle aggregate was composed of silver particles having a primary particle diameter of 200 nm or less. A proportion (a concentration of the silver particles) of a content of the silver particles in the sintered material to the total mass of the sintered material was 30% by mass.

### <<Production and Evaluation of Joined Body (Metal Sintered Compact)>>

A joined body (metal sintered compact) was produced and evaluated by the same method as in the case of Example 1, except that the sintered material obtained above was used. The results are shown in Table 2.

### <<Production of Sintered Material, Production of Joined Body (Metal Sintered Compact), and Evaluation of Joined Body (Metal Sintered Compact)>>

### [Example 8]

A sintered material and a joined body (metal sintered compact) were produced by the same method as in the case of Example 7, except that during the formation of the metal sintered compact, the laminate was finally subjected to a temperature rise to 250°C and held at 250°C for 60 minutes as it was, instead of subjecting the laminate to a temperature rise to 200°C and holding it at 200°C for 60 minutes as it was. The joined body (metal sintered compact) was evaluated. The results are shown in Table 2.

### [Example 9]

A sintered material and a joined body (metal sintered compact) were produced by the same method as in the case of Example 7, except that during the formation of the metal sintered compact, the laminate was finally subjected to a temperature rise to 300°C and held at 300°C for 60 minutes as it was, instead of subjecting the laminate to a temperature rise to 200°C and holding it at 200°C for 60 minutes as it was. The joined body (metal sintered compact) was evaluated. The results are shown in Table 2.

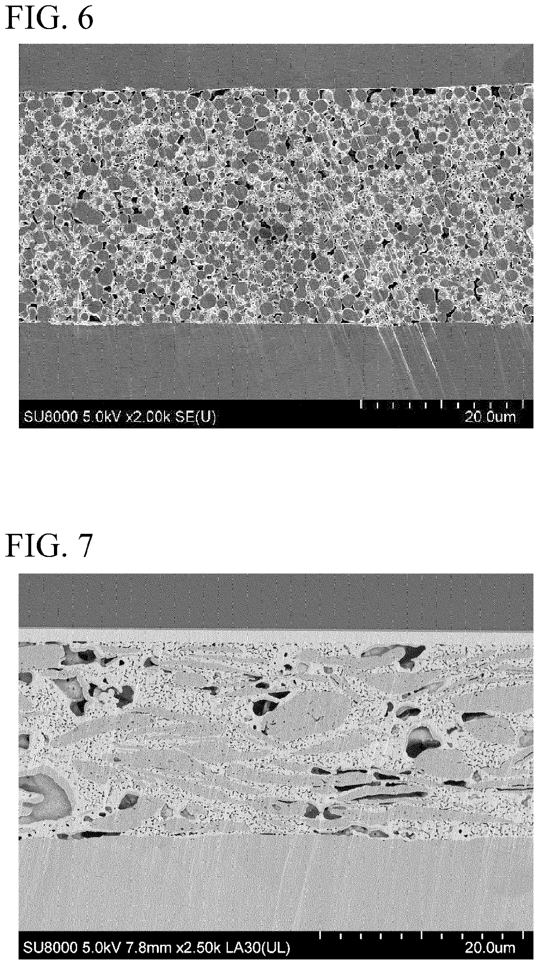

In addition, imaging data acquired in observation of the cross-section of the joined body by SEM-EDS are shown in FIG. 6.

### [Example 10]

A sintered material and a joined body (metal sintered compact) were produced by the same method as in the case of Example 7, except that during the formation of the metal sintered compact, the laminate was finally subjected to a temperature rise to 350°C and held at 350°C for 60 minutes as it was, instead of subjecting the laminate to a temperature rise to 200°C and holding it at 200°C for 60 minutes as it was. The joined body (metal sintered compact) was evaluated. The results are shown in Table 2.

### [Example 11]

### <<Production of Sintered Material>>

The silver-containing composition (A) was obtained by the same method as in Example 1.

The silver-containing composition (A) (20 parts by mass) obtained above, copper particles (b) (manufactured by Mitsui Mining & Smelting Co., Ltd., MA-C08JF, D50: 12 µm, tap density: 3 g/cm³, flaky) (10 parts by mass), polyethylene glycol 300 (PEG300 manufactured by Fujifilm Wako Pure Chemical Corporation) (1 part by mass), and ascorbic acid (manufactured by FUJIFILM Wako Pure Chemical Corporation) (0.1 parts by mass) were mixed and stirred at normal temperature to obtain a sintered material.

### <<Production of Joined Body (Metal Sintered Compact)>>

A copper plate having a size of 10 mm × 10 mm and a thickness of 0.8 mm, and a silicon chip having a size of 3 mm × 3 mm and a thickness of 0.5 mm and having a square planar shape were prepared.

A titanium layer having a thickness of 100 nm and a silver layer having a thickness of 1 µm were formed on the joint surface of the silicon chip in that order from the silicon chip side by a sputtering method.

A printing layer having a size of 3 mm × 3 mm and a thickness of 0.1 mm of the sintered material obtained above was formed on one surface of the copper plate by a screen printing method.

Next, the printing layer was pre-heated at 80°C for 2 minutes under the conditions of no pressure (under normal pressure) in an atmosphere, using Program Hot Plate (manufactured by AS ONE Corporation), and then the silicon chip was placed on the heated product (pre-heated product) of the printing layer. At this time, the silver layer provided in the silicon chip was brought into contact with the heated product (pre-heated product) of the printing layer. In addition, in a state in which these (the silicon chip and the heated product) were viewed from above in a plan view, the center of the heated product and the center of the silicon chip were matched. Further, the silicon chip was arranged so that the outer circumference of the heated product and the outer circumference of the silicon chip were parallel to each other.

Next, the obtained laminate was subjected to a temperature rise from room temperature to 120°C at a temperature rising rate of 5°C/min while applying a pressure of 2 MPa to the laminate in a thickness direction thereof, and held at 120°C for 5 minutes as it was; subjected to a temperature rise from 120°C to 190°C at a temperature rising rate of 5°C/min and held at 190°C for 5 minutes as it was; and subjected to a temperature rise from 190°C to 300°C at a temperature rising rate of 5°C/min and held at 300°C for 60 minutes as it was, in an atmosphere, to calcine the heated product. During this time, the temperature was raised from room temperature, and the above-described pressure of 2 MPa was continuously applied to the laminate until the holding at 300°C for 60 minutes ended. Thus, a metal sintered compact having a size of 3 mm × 3 mm was formed from the heated product.

Next, the obtained calcined product was allowed to be cooled to room temperature.

Thus, a joined body configured by joining the copper plate, and the silicon chip provided with the titanium layer and the silver layer through the joining section consisting of the metal sintered compact was obtained.

### «Evaluation of Joined Body (Metal Sintered Compact)»

The joined body (metal sintered compact) obtained above was evaluated by the same method as in the case of Example 1. The results are shown in Table 2.

In addition, imaging data acquired in observation of the cross-section of the joined body by SEM-EDS are shown in FIG. 7.

### [Example 12]

### <<Production of Sintered Material>>

A sintered material was obtained by the same method as in the case of Example 11.

### <<Production of Joined Body (Metal Sintered Compact)>>

By the same method as in the case of Example 11, except that the pre-heating of the printing layer was performed at 80°C for 1 minute instead of being performed at 80°C for 2 minutes, a laminate of a copper plate, the heated product (pre-heated product) of the printing layer, and a silicon chip provided with a titanium layer and a silver layer was obtained.

Next, the obtained laminate was subjected to a temperature rise from room temperature to 120°C at a temperature rising rate of 5°C/min while applying a pressure of 2 MPa to the laminate in a thickness direction thereof, and held at 120°C for 5 minutes as it was; and subjected to a temperature rise from 120°C to 180°C at a temperature rising rate of 5°C/min and held at 180°C for 60 minutes as it was, in an atmosphere, to calcine the heated product. During this time, the temperature was raised from room temperature, and the above-described pressure of 2 MPa was continuously applied to the laminate until the holding at 180°C for 60 minutes ended. Thus, a metal sintered compact having a size of 3 mm × 3 mm was formed from the heated product.

Next, the obtained calcined product was allowed to be cooled to room temperature.

Thus, a joined body configured by joining the copper plate, and the silicon chip provided with the titanium layer and the silver layer through the joining section consisting of the metal sintered compact was obtained.

### «Evaluation of Joined Body (Metal Sintered Compact)»

The joined body (metal sintered compact) obtained above was evaluated by the same method as in the case of Example 1. The results are shown in Table 3.

### [Example 13]

### <<Production of Sintered Material>>

A sintered material was obtained by the same method as in the case of Example 11.

### <<Production of Joined Body (Metal Sintered Compact)>>

By the same method as in the case of Example 11, except that the pre-heating of the printing layer was performed at 80°C for 1 minute instead of being performed at 80°C for 2 minutes, a laminate of a copper plate, the heated product (pre-heated product) of the printing layer, and a silicon chip provided with a titanium layer and a silver layer was obtained.

Next, the obtained laminate was subjected to a temperature rise from room temperature to 120°C at a temperature rising rate of 5°C/min while applying a pressure of 2 MPa to the laminate in a thickness direction thereof, and held at 120°C for 5 minutes as it was; subjected to a temperature rise from 120°C to 190°C at a temperature rising rate of 5°C/min and held at 190°C for 5 minutes as it was; and subjected to a temperature rise from 190°C to 200°C at a temperature rising rate of 5°C/min and held at 200°C for 60 minutes as it was, in an atmosphere, to calcine the heated product. During this time, the temperature was raised from room temperature, and the above-described pressure of 2 MPa was continuously applied to the laminate until the holding at 200°C for 60 minutes ended. Thus, a metal sintered compact having a size of 3 mm × 3 mm was formed from the heated product.

Next, the obtained calcined product was allowed to be cooled to room temperature.

Thus, a joined body configured by joining the copper plate and the copper chip to each other through the joining section formed from the metal sintered compact was obtained.

### «Evaluation of Joined Body (Metal Sintered Compact)»

The joined body (metal sintered compact) obtained above was evaluated by the same method as in the case of Example 1. The results are shown in Table 3.

### <<Production of Sintered Material, Production of Joined Body (Metal Sintered Compact), and Evaluation of Joined Body (Metal Sintered Compact)>>

### [Example 14]

A sintered material and a joined body (metal sintered compact) were produced by the same method as in the case of Example 13, except that during the formation of the metal sintered compact, the laminate was finally subjected to a temperature rise to 250°C and held at 250°C for 60 minutes, instead of subjecting the laminate to a temperature rise to 200°C and holding it at 200°C for 60 minutes as it was. The joined body (metal sintered compact) was evaluated. The results are shown in Table 3.

### [Example 15]

A sintered material and a joined body (metal sintered compact) were produced by the same method as in the case of Example 13, except that during the formation of the metal sintered compact, the laminate was finally subjected to a temperature rise to 280°C and held at 280°C for 60 minutes as it was, instead of subjecting the laminate to a temperature rise to 200°C and holding it at 200°C for 60 minutes as it was. The joined body (metal sintered compact) was evaluated. The results are shown in Table 3.

### [Example 16]

A sintered material and a joined body (metal sintered compact) were produced by the same method as in the case of Example 13, except that during the formation of the metal sintered compact, the laminate was finally subjected to a temperature rise to 300°C and held at 300°C for 60 minutes as it was, instead of subjecting the laminate to a temperature rise to 200°C and holding it at 200°C for 60 minutes as it was. The joined body (metal sintered compact) was evaluated. The results are shown in Table 3.

### [Example 17]

A sintered material and a joined body (metal sintered compact) were produced by the same method as in the case of Example 13, except that during the formation of the metal sintered compact, the laminate was finally subjected to a temperature rise to 350°C and held at 350°C for 60 minutes as it was, instead of subjecting the laminate to a temperature rise to 200°C and holding it at 200°C for 60 minutes as it was. The joined body (metal sintered compact) was evaluated. The results are shown in Table 3.

### [Example 18]

### <<Production of Sintered Material>>

A sintered material was obtained by the same method as in the case of Example 11.

### <<Production of Joined Body (Metal Sintered Compact)>>

A first copper plate having a size of 50 mm × 50 mm and a thickness of 0.8 mm was prepared. In addition, as a direct bonded copper (DBC) substrate, a substrate including an aluminum oxide (Al₂O₃) plate having a size of 32 mm × 32 mm, a thickness of 0.63 mm, and a square planar shape, and a second copper plate provided on both surfaces of the aluminum oxide plate, having a size of 30 mm × 30 mm, a thickness of 0.3 mm, and a square planar shape, in which, while the aluminum oxide plate and the second copper plate were viewed from above in a plan view, the aluminum oxide plate and two sheets of the second copper plates were arranged so that the center of the aluminum oxide plate and the centers of the two second copper plates coincided with each other, and further, the outer circumference of the aluminum oxide plate and the outer circumferences of the two second copper plates were parallel to each other, was prepared.

A printing layer having a size of 30 mm × 30 mm and a thickness of 0.1 mm of the sintered material obtained above was formed on one surface of the first copper plate by a screen printing method.

Next, the printing layer was pre-heated at 80°C for 1 minute under the conditions of no pressure (under normal pressure) in an atmosphere, using Program Hot Plate (manufactured by AS ONE Corporation), and then the DBC substrate was placed on the heated product (pre-heated product) of the printing layer. At this time, one of the second copper plates in the DBC substrate was brought into contact with the heated product (pre-heated product) of the printing layer. In addition, in a state where these (the DBC substrate and the heated product) were viewed from above in a plan view, the center of the heated product and the center of the DBC substrate were matched with each other. Further, the DBC substrate was arranged so that the outer circumference of the heated product and the outer circumference of the DBC substrate were parallel to each other.

Next, the obtained laminate was subjected to a temperature rise from room temperature to 80°C at a temperature rising rate of 10°C/min while applying a pressure of 5 MPa to the obtained laminate in the thickness direction, and held at 80°C for 20 minutes as it was; subjected to a temperature rise from 80°C to 120°C at a temperature rising rate of 10°C/min and held at 120°C for 20 minutes as it was; subjected to a temperature rise from 120°C to 190°C at a temperature rising rate of 10°C/min and held at 190°C for 20 minutes as it was; and subjected to a temperature rise from 190°C to 300°C at a temperature rise rate of 10°C/min and held at 300°C for 90 minutes as it was in an atmosphere to calcine the heated product. During this time, until the laminate was subjected to a temperature rise from room temperature, and until the laminate was held at 300°C for 90 minutes, the above-described pressure of 5 MPa was continuously applied to the laminate. Thus, a metal sintered compact having a size of 30 mm × 30 mm was formed from the heated product.

Next, the obtained calcined product was allowed to be cooled to room temperature.

As described above, a joined body configured by joining the first copper plate and the DBC substrate to each other through the joining section consisting of the metal sintered compact was obtained.

### «Evaluation of Joined Body (Metal Sintered Compact)»

### <Measurement of Die Shear Strength>

The joined body obtained above was cut into 36 small pieces having a size of 5 mm × 5 mm and a square planar shape.

14 small pieces were randomly selected from these 36 small pieces, the die shear strengths of these 14 small pieces (joined bodies) were calculated by the same method as in the case of the joined body in Example 1, and an average value thereof was adopted as a die shear strength of the joined body. The results are shown in Table 4.

### [Comparative Example 1]

### <<Production of Sintered Material>>

Copper particles (a) (manufactured by Fukuda Metal Foil & Powder Co., Ltd., CU-HWQ Grade 1.5 µm, D50: 1 to 2 µm, tap density: 3 to 4 g/cm³, spherical) (10 parts by mass), polyethylene glycol 300 (PEG300 manufactured by Fujifilm Wako Pure Chemical Corporation) (1 part by mass), and ascorbic acid (manufactured by FUJIFILM Wako Pure Chemical Corporation) (0.1 parts by mass) were mixed and stirred at normal temperature to obtain a sintered material.

### <<Production and Evaluation of Joined Body (Metal Sintered Compact)>>

A joined body (metal sintered compact) was produced and evaluated by the same method as in the case of Example 1, except that the sintered material obtained above was used. The results are shown in Table 4.

### <<Production of Sintered Material, Production of Joined Body (Metal Sintered Compact), and Evaluation of Joined Body (Metal Sintered Compact)>>

### [Comparative Example 2]

A sintered material and a joined body (metal sintered compact) were produced by the same method as in the case of Comparative Example 1, except that during the formation of the metal sintered compact, the laminate was finally subjected to a temperature rise to 250°C and held at 250°C for 60 minutes as it was, instead of subjecting the laminate to a temperature rise to 200°C and holding it at 200°C for 60 minutes as it was. The joined body (metal sintered compact) was evaluated. The results are shown in Table 4.

### [Comparative Example 3]

A sintered material and a joined body (metal sintered compact) were produced by the same method as in the case of Comparative Example 1, except that during the formation of the metal sintered compact, the laminate was finally subjected to a temperature rise to 300°C and held at 300°C for 60 minutes as it was, instead of subjecting the laminate to a temperature rise to 200°C and holding it at 200°C for 60 minutes as it was. The joined body (metal sintered compact) was evaluated. The results are shown in Table 4.

**[Table 1]**

| | | Example | | | | | |
|---|---|---|---|---|---|---|---|
| | | 1 | 2 | 3 | 4 | 5 | 6 |
| Blending component of sintered material (parts by mass) | Silver-containing composition | Silver-containing composition (A) (10) | | | Silver-containing composition (A) (10) | | |
| | Copper particles | Copper particles (a) (10) | | | Copper particles (a) (10) | | |
| | Liquid component | - | | | PEG300 (1) | | |
| | Antioxidative compound | - | | | - | | |
| Primary particle diameter of silver particles (nm) | | 200 or less | | | 200 or less | | |
| Average secondary particle diameter of silver particles (nm) | | 294 | | | 294 | | |
| D50 of copper particles (µm) | | 1 to 2 | | | 1 to 2 | | |
| Joining conditions | Pre-heating temperature (°C) | 80 | 80 | 80 | 80 | 80 | 80 |
| | Pre-heating time (min) | 2 | 2 | 2 | 2 | 2 | 2 |
| | Pressure during calcining (MPa) | 1 | 1 | 1 | 1 | 1 | 1 |
| | Final calcining temperature (°C) | 200 | 250 | 300 | 200 | 250 | 300 |
| | Final calcining time (min) | 60 | 60 | 60 | 60 | 60 | 60 |
| Evaluation results | Die shear strength (MPa) | C (16.6) | B (26.7) | B (23.4) | C (13.9) | A (47.0) | B (31.7) |
| | Presence or absence of oxidized layer | Absent | Absent | Present | Absent | Present | Present |

**[Table 2]**

| | | Example | | | | |
|---|---|---|---|---|---|---|
| | | 7 | 8 | 9 | 10 | 11 |
| Blending component of sintered material (parts by mass) | Silver-containing composition | Silver-containing composition (A) (10) | | | | Silver-containing composition (A) (20) |
| | Copper particles | Copper particles (a) (10) | | | | Copper particles (b) (10) |
| | Liquid component | PEG300 (1) | | | | PEG300 (1) |
| | Antioxidative compound | Ascorbic acid (0.1) | | | | Ascorbic acid (0.1) |
| Primary particle diameter of silver particles (nm) | | 200 or less | | | | 200 or less |
| Average secondary particle diameter of silver particles (nm) | | 294 | | | | 294 |
| D50 of copper particles (µm) | | 1 to 2 | | | | 12 |
| Joining conditions | Pre-heating temperature (°C) | 80 | 80 | 80 | 80 | 80 |
| | Pre-heating time (min) | 2 | 2 | 2 | 2 | 2 |
| | Pressure during calcining (MPa) | 1 | 1 | 1 | 1 | 2 |
| | Final calcining temperature (°C) | 200 | 250 | 300 | 350 | 300 |
| | Final calcining time (min) | 60 | 60 | 60 | 60 | 60 |
| Evaluation results | Die shear strength (MPa) | C (9.2) | B (28.2) | A (43.3) | B (32.6) | B (31.0) |
| | Presence or absence of oxidized layer | Absent | Absent | Absent | Present | Absent |

**[Table 3]**

| | | Example | | | | | |
|---|---|---|---|---|---|---|---|
| | | 12 | 13 | 14 | 15 | 16 | 17 |
| Blending component of sintered material (parts by mass) | Silver-containing composition | Silver-containing composition (A) (20) | | | | | |
| | Copper particles | Copper particles (b) (10) | | | | | |
| | Liquid component | PEG300 (1) | | | | | |
| | Antioxidative compound | Ascorbic acid (0.1) | | | | | |
| Primary particle diameter of silver particles (nm) | | 200 or less | | | | | |
| Average secondary particle diameter of silver particles (nm) | | 294 | | | | | |
| D50 of copper particles (µm) | | 12 | | | | | |
| Joining conditions | Pre-heating temperature (°C) | 80 | 80 | 80 | 80 | 80 | 80 |
| | Pre-heating time (min) | 1 | 1 | 1 | 1 | 1 | 1 |
| | Pressure during calcining (MPa) | 2 | 2 | 2 | 2 | 2 | 2 |
| | Final calcining temperature (°C) | 180 | 200 | 250 | 280 | 300 | 350 |
| | Final calcining time (min) | 60 | 60 | 60 | 60 | 60 | 60 |
| Evaluation results | Die shear strength (MPa) | C (16.9) | C (19.1) | A (45.9) | A (50.0) | A (56.7) | A (55.9) |
| | Presence or absence of oxidized layer | Absent | Absent | Absent | Absent | Absent | Present |

**[Table 4]**

| | | Example | Comparative Example | | |
|---|---|---|---|---|---|
| | | 18 | 1 | 2 | 3 |
| Blending component of sintered material (parts by mass) | Silver-containing composition | Silver-containing composition (A) (20) | - | | |
| | Copper particles | Copper particles (b) (10) | Copper particles (a) (10) | | |
| | Liquid component | PEG300 (1) | PEG300 (1) | | |
| | Antioxidative compound | Ascorbic acid (0.1) | Ascorbic acid (0.1) | | |
| Primary particle diameter of silver particles (nm) | | 200 or less | - | | |
| Average secondary particle diameter of silver particles (nm) | | 294 | - | | |
| D50 of copper particles (µm) | | 12 | 1 to 2 | | |
| Joining conditions | Pre-heating temperature (°C) | 80 | 80 | 80 | 80 |
| | Pre-heating time (min) | 1 | 2 | 2 | 2 |
| | Pressure during calcining (MPa) | 5 | 1 | 1 | 1 |
| | Final calcining temperature (°C) | 300 | 200 | 250 | 300 |
| | Final calcining time (min) | 90 | 60 | 60 | 60 |
| Evaluation results | Die shear strength (MPa) | B (31.9) | D (0) | D (0) | D (0) |
| | Presence or absence of oxidized layer | - | Present | Present | Present |

As is clear from the results, in Examples 1 to 18, a joined body could be produced with sufficient joining strength without a need to apply high pressure in an atmosphere, using a sintered material containing copper particles.

In Examples 1 to 18, the sintered material contained silver particles, copper particles, a nitrogen-containing compound, and a reducing agent, the primary particle diameter of the silver particles was 200 nm or less, and a D50 of the copper particles was 1 to 12 µm.

From a comparison between Examples 2 and 3 and Examples 5 and 6, it could be confirmed that incorporating the liquid component into the sintered material increased the joining strength (die shear strength) of the joined body. However, from Examples 1 to 3 and Examples 4 to 6, it could be confirmed that as the final calcining temperature increases, an oxidized layer tends to be more easily formed on the surfaces of copper particles inside the joining section and the surface of the copper plate. Furthermore, from a comparison between Example 2 and Example 5, it could be confirmed that when the liquid component (PEG300) is incorporated, an oxidized layer tends to be easily formed on the surfaces of copper particles inside the joining section and the surface of the copper plate.

From the comparison between Examples 5 and 6 and Examples 8 and 9, it could be confirmed that incorporating the antioxidative compound into the sintered material does not decrease the joining strength of the joined body, and the formation of an oxidized layer on the surfaces of the copper particles inside the joining section and the surface of the copper plate can be suppressed. Furthermore, from the results of Example 11 and Examples 15 and 16, it could be confirmed that even in a case where the final calcining temperature was high, incorporating the antioxidative compound into the sintered material does not decrease the joining strength of the joined body, and the formation of an oxidized layer on the surfaces of copper particles inside the joining section and the surface of the copper plate can be suppressed.

From a comparison of Examples 7 to 10 and a comparison of Examples 12 to 17, it could be confirmed that in a case where the final calcining temperature is high, the joining strength of the joined body is increased, but in a case where the final joining temperature is too high, the joining strength of the joined body tends to be decreased.

From the results of Example 16 and Example 18, it could be confirmed that even in a case where the joint surface of the metal-made member is increased, a joined body can be produced with sufficient joining strength without a need to apply high pressure in an atmosphere, using a sintered material containing copper particles.

Furthermore, in Example 18, the die shear strength of all 14 small pieces was 18 MPa or more.

From FIG. 6, it could be confirmed that in the joined body obtained in Example 9, the copper particles inside the joining section were present in a particulate form, the silver particles were fused to each other, and the silver particles in the fused state coated the surfaces of the copper particles and were further in direct contact with the surface of the copper plate. In FIG. 6, the copper particles could be confirmed as black particles, and the silver particles in a fused state could be confirmed as a white region surrounding the copper particles.

The same results were confirmed from FIG. 7 as well. That is, in the joined body obtained in Example 11 as well, the copper particles inside the joining section were present in a particulate form, the silver particles were fused to each other, and the silver particles in the fused state coated the surfaces of the copper particles and were further in direct contact with the surface of the copper plate. In FIG. 7, the copper particles could be confirmed as light gray particles, and the silver particles in a fused state could be confirmed as a white region surrounding the copper particles.

On the other hand, in Comparative Examples 1 to 3, a joined body could not be produced with sufficient joining strength without a need to apply high pressure in an atmosphere, using a sintered material containing copper particles.

In Comparative Examples 1 to 3, the sintered materials contained none of silver particles, a nitrogen-containing compound, and a reducing agent.

### [Industrial Applicability]

The present invention can be used as a conductive joined body, particularly a semiconductor device.

### [Reference Signs List]

1, 11, 12: Joining section (metal sintered compact)
121: First joining section (first metal sintered compact)
122: Second joining section (second metal sintered compact)
10: Sintered material
110: First sintered material
120: Second sintered material
100: Heated product of sintered material
1100: Heated product of first sintered material (first heated product)
1200: Heated product of second sintered material (second heated product)
2: Conductive first part
2a: One surface of conductive first part
20: Substrate
21: Electrode
3: Conductive second part
3a: One surface of conductive second part
31: Semiconductor element
101, 103, 104: Joined body
102: Semiconductor device

## Claims

1. A sintered material comprising:
silver particles;
copper particles;
a nitrogen-containing compound; and
a reducing agent,
wherein a primary particle diameter of the silver particles is 200 nm or less, and
a volume-based 50% cumulative particle diameter of the copper particles, as measured by laser diffraction/scattering particle diameter distribution measurement, is 1 µm or more.

2. The sintered material according to Claim 1, further comprising:
a liquid component that is liquid at normal temperature,
wherein the liquid component has either one or both of an ether bond and a hydroxyl group.

3. The sintered material according to Claim 1 or 2, further comprising:
an antioxidative compound having a boiling point of 150°C or higher.

4. A metal sintered compact comprising:
a silver sintered layer,
wherein the silver sintered layer contains copper particles,
a volume-based 50% cumulative particle diameter of the copper particles, as measured by laser diffraction/scattering particle diameter distribution measurement, is 1 µm or more, and
surfaces of the copper particles do not have an oxidized layer.

5. The metal sintered compact according to Claim 4,
wherein, in a case where a metal joined body in which metal-made members are joined to each other by the metal sintered compact is subjected to a lateral shear strength test in accordance with JIS C62137-1-2:2010, a lateral shear strength of the metal joined body is 20 MPa or more.

6. A method for producing a sintered material, the method comprising:
a step of blending a silver carboxylate having a group represented by the formula "-COOAg", a nitrogen-containing compound, and a reducing agent to prepare a silver-containing composition; and
a step of blending the silver-containing composition and copper particles,
wherein a volume-based 50% cumulative particle diameter of the copper particles, as measured by laser diffraction/scattering particle diameter distribution measurement, is 1 µm or more.

7. A method for producing a joined body configured to have a conductive first part and a conductive second part joined to each other through a joining section which is a metal sintered compact, the method comprising:
a step of heating a sintered material attached to either one or both surfaces of the first part and the second part at a temperature of 60°C or higher without solidification to obtain a heated product of the sintered material; and
a step of calcining the heated product while bringing the first part and the second part into contact with each other through the heated product interposed between the parts in an atmosphere to join the first part and the second part to each other by the metal sintered compact formed from the heated product,
wherein the sintered material contains silver particles, copper particles, a nitrogen-containing compound, and a reducing agent,
a primary particle diameter of the silver particles is 200 nm or less, and
a volume-based 50% cumulative particle diameter of the copper particles, as measured by laser diffraction/scattering particle diameter distribution measurement, is 1 µm or more.

8. A joined body configured to have a conductive first part and a conductive second part joined to each other through a joining section which is a metal sintered compact,
wherein the metal sintered compact has a silver sintered layer,
the silver sintered layer contains copper particles,
a volume-based 50% cumulative particle diameter of the copper particles, as measured by laser diffraction/scattering particle diameter distribution measurement, is 1 µm or more,
an area of a joint surface of both the first part and the second part is 625 mm² or more,
the first part and the second part are made of copper, silver, aluminum, gold, or nickel, and
in a case where the joined body is cut into a small piece having a size of 5 mm × 5 mm, including the first part, the second part, and the joining section, and the small piece is subjected to a lateral shear strength test in accordance with JIS C62137-1-2:2010, a lateral shear strength of the small piece is 18 MPa or more.
